# EUROPÄISCHE PATENTSCHRIFT

(11) **EP 3 278 355 B1**
(45) Veröffentlichungstag und Bekanntmachung des Hinweises auf die Patenterteilung: **05.06.2019**
(21) Anmeldenummer: 16713444.4
(22) Anmeldetag: 31.03.2016
(51) Int. Cl.: H01L 21/67, H01L 21/673, H01J 37/32, H01L 21/677, H01L 21/687

(54) **WAFERBOOT UND BEHANDLUNGSVORRICHTUNG FÜR WAFER**
WAFER BOAT AND TREATMENT APPARATUS FOR WAFERS
BAC DE PLAQUETTES ET DISPOSITIF DE TRAITEMENT DE PLAQUETTES

(30) Priorität: 02.04.2015 DE 102015004352
(43) Veröffentlichungstag der Anmeldung: 07.02.2018
(73) Patentinhaber: Lerch, Wilfried, 89160 Dornstadt/Tomerdingen (DE)
(72) Erfinder: KLICK, Michael, 12489 Berlin (DE); ROTHE, Ralf, 12489 Berlin (DE); LERCH, Wilfried, 89160 Dornstadt/Tomerdingen (DE); REHLI, Johannes, 89143 Blaubeuren (DE)
(74) Vertreter: Klang, Alexander H.
(86) Internationale Anmeldenummer: PCT/EP2016/057173
(87) Internationale Veröffentlichungsnummer: WO 2016/156551

(56) Entgegenhaltungen:
- DE-A1-102011 109 444

## Beschreibung

Die vorliegende Erfindung betrifft ein Waferboot und eine Behandlungsvorrichtung für Wafer, die zum Erzeugen eines Plasmas zwischen darin aufgenommenen Wafern geeignet sind.

In der Halbleiter- sowie der Solarzellentechnik ist es bekannt, scheibenförmige Substrate aus unterschiedlichen Materialien, die nachfolgend unabhängig von ihrer geometrischen Form und ihrem Material als Wafer bezeichnet werden, unterschiedlichen Prozessen auszusetzen.

Dabei werden die Wafer häufig sowohl Einzelbehandlungsprozessen als auch Chargenprozessen, d.h. Prozessen bei denen mehrere Wafer gleichzeitig behandelt werden, ausgesetzt. Sowohl für Einzelprozesse als auch Chargenprozesse müssen die Wafer jeweils in eine gewünschte Behandlungsposition gebracht werden. Bei Chargenprozessen geschieht dies in der Regel dadurch, dass die Wafer in sogenannte Boote eingesetzt werden, welche Aufnahmen für eine Vielzahl von Wafern besitzen. In den Booten werden die Wafer in der Regel jeweils parallel zueinander angeordnet. Solche Boote können unterschiedlich aufgebaut sein, und häufig sehen sie nur eine Aufnahme der unteren Kanten der jeweiligen Wafer derart vor, dass die Wafer nach oben freistehen. Solche Boote können beispielsweise Einführschrägen aufweisen, um das Einsetzen der jeweiligen unteren Kanten der Wafer in die Boote zu erleichtern. Solche Boote sind in der Regel passiv, dass heißt neben einer Haltefunktion haben sie keine weitere Funktion während der Prozessierung der Wafer.

Bei einem Typ von Waferboot, das beispielsweise für eine Plasmaprozessierung von Wafern in der Halbleiter- oder Solarzellentechnologie verwendet wird, ist das Waferboot durch eine Vielzahl von elektrisch leitenden Platten gebildet, die üblicherweise aus Graphit bestehen. Die Platten sind im Wesentlichen parallel zueinander angeordnet, und zwischen benachbarten Platten werden Aufnahmeschlitze zur Aufnahme von Wafern gebildet. Die zueinander weisenden Seiten der Platten besitzen jeweils entsprechende Aufnahmeelemente für Wafer, so dass an jeder dieser Seiten Wafer aufgenommen werden können. Als Aufnahmeelemente sind üblicherweise an jeder zu einer anderen Platte weisenden Plattenseite Stifte vorgesehen, welche den Wafer aufnehmen. In jedem Aufnahmeschlitz können somit wenigstens zwei Wafer derart vollständig zwischen den Platten aufgenommen werden, dass sie einander gegenüberliegen. Benachbarte Platten des Waferbootes sind elektrisch gegeneinander isoliert und zwischen direkt benachbarten Platten wird während des Prozesses eine Wechselspannung üblicherweise im kHz-Bereich oder auch im MHz-Bereich angelegt. Hierdurch soll zwischen den Platten und insbesondere zwischen den an den jeweiligen Platten gehaltenen Wafern ein Plasma ausgebildet werden, um eine Plasmabehandlung wie zum Beispiel eine Schichtabscheidung aus dem Plasma oder eine Plasmanitridierung von Schichten vorzusehen.

Für die Anordnung der Platten zueinander werden Abstandselemente eingesetzt, die jeweils eine vorbestimmte Länge zur Einstellung vorbestimmter Abstände zwischen den Platten besitzen. Die Abstandselemente besitzen ferner jeweils eine sich längs erstreckende Durchgangsöffnung zur Durchführung eines Befestigungselementes, wie zum Beispiel einer Schraube, Ein solches Befestigungselement kann sich durch alle, oder einen Teil der Platten und dazwischen befindliche Abstandselemente hindurch erstrecken, um die Elemente aneinander zu befestigen. Ein Beispiel eines solchen Waferbootes, das aus Platten und Abstandselementen aufgebaut ist, ist in der DE 10 2011 109 444 A1 beschrieben. Insbesondere sind hier elektrisch isolierende Abstandselemente sowie isolierende Befestigungselemente zur elektrischen Isolierung benachbarter Platten eingesetzt, die spezielle Ablauföffnungen für Ätz- und/oder Spülflüssigkeiten aufweisen. Ferner werden an Kontaktenden der Platten auch elektrisch leitende Elemente eingesetzt, um beispielsweise jeweils jede zweite Platte mit einem gleichen Potential beaufschlagen zu können. Diese leitenden Elemente besitzen einen möglichst geringen Widerstand, um eine gleichmäßige Beaufschlagung der Platten zu ermöglichen.

Für eine Abscheidung aus dem Plasma ist es üblicherweise zusätzlich notwendig, die Wafer auf eine vorbestimmte Temperatur zu erwärmen. Hierfür wird das Waferboot mit darin aufgenommenen Wafern üblicherweise in einem Prozessrohr aufgenommen, das über eine Heizeinrichtung beheizbar ist und somit die Wafer und das Prozessboot aufheizen kann. Obwohl die Temperatur an den außen liegenden Platten recht schnell erreicht werden kann, dauert die Aufheizung innen liegender Platten und der innen liegenden Wafer mitunter recht lang, was die Prozesszyklen verlängert.

Der vorliegenden Erfindung liegt daher die Aufgabe zugrunde, ein Waferboot und ein Verfahren zur Plasmabehandlung von Wafern vorzusehen, welche eine verbesserte Aufheizung der Wafer ermöglichen.

Erfindungsgemäß wird diese Aufgabe durch ein Waferboot nach Anspruch 1, eine Plasma-Behandlungsvorrichtung nach Anspruch 10 sowie ein Verfahren nach Anspruch 12 gelöst. Weitere Ausgestaltungen der Erfindung ergeben sich aus den jeweiligen Unteransprüchen,

Insbesondere ist ein Waferboot für die Plasmabehandlung von scheibenförmigen Wafern, insbesondere Halbleiterwafern für Halbleiter- oder Photovoltaikanwendungen vorgesehen. Das Waferboot weist eine Vielzahl von parallel zueinander angeordneten Platten aus einem elektrisch leitenden Material auf, die an ihren zueinander weisenden Seiten jeweils wenigstens eine Aufnahme für einen Wafer aufweisen, sowie eine Vielzahl von Abstandselementen, die zwischen direkt benachbarten Platten angeordnet sind, um die Platten parallel anzuordnen, wobei die Abstandselemente elektrisch leitend sind. Im Gegensatz zu herkömmlichen Waferbooten, die einen ähnlichen Aufbau besitzen, sind die Abstandselemente hier elektrisch leitend, was deren Einsatz als Widerstandsheizelemente in einer Aufheizphase einer Waferbehandlung ermöglicht. Hierdurch kann eine kurze Aufheizphase erreicht werden, da die Abstandselemente gezielt in die Zwischenräume zwischen den Platten Wärme abgeben können.

Für eine homogene Aufheizung können die Abstandselemente jeweils gleichmäßig um den Aufnahmebereich der Platten herum angeordnet sein. Bevorzugt sind jeweils wenigstens vier der Abstandselemente um einen entsprechenden Aufnahmebereich der Platten herum angeordnet.

Bei einer Ausführungsform weisen die Abstandselemente jeweils einen Widerstand von wenigstens 20 kΩ, bevorzugt im Bereich von 40 kΩ auf, wodurch sie einerseits gut als Widerstandsheizelemente eingesetzt werden können, in einer Hochfrequenzanwendung aber eine Wellenausbreitung zwischen den Platten nicht wesentlich beeinflussen. Für eine gute Einstellbarkeit des gewünschten Widerstandes und um Kontaminationen des Behandlungsprozesses zu vermeiden können die Abstandselemente aus Polysilizium bestehen wobei der Widerstand der Abstandelemente über eine Dotierung des Grundmaterials eingestellt sein kann. Der Widerstand der Abstandselemente ist bevorzugt derart gewählt ist, dass bei einer Beaufschlagung des Waferbootes mit einer Hochfrequenzspannung nur der kleinere Teil (mithin weniger als 50% und bevorzugt weniger als 30%) der eingekoppelten Hochfrequenzleistung an den Abstandelementen in Wärme ungesetzt wird.

Bevorzugt weisen die Platten an ihren Längsenden jeweils Kontaktnasen auf, die über Kontaktblöcke mit Kontaktnasen anderer Platten verbunden sind, wobei die Kontaktnasen direkt benachbarter Platten in unterschiedlichen Ebenen liegen und die Kontaktblöcke jeweils jede zweite Platte miteinander verbinden. Dies ermöglicht auf einfache Weise das Anlegen einer Spannung zwischen den Platten, um einerseits über die Abstandselemente aufzuheizen und/oder ein Plasma zwischen den Platten und insbesondere zwischen an den Platten aufgenommenen Wafern zu erzeugen. Bevorzugt ist die kombinierte thermische Masse der Summe der Kontaktblöcke und der Summe der Kontaktnasen kleiner als die thermische Masse des sonstigen Waferbootes. Insbesondere ist die kombinierte thermische Masse der Summe der Kontaktblöcke und der Summe der Kontaktnasen kleiner ist als 1/10 der thermischen Masse des sonstigen Waferbootes, um eine rasche Aufheizung zu ermöglichen. Ferner ist bevorzugt die Zuleitungsimpedanz über jeweils stromdurchflossene Kontaktblöcke und zwei Kontaktnasen kleiner als die Impedanz eines Plasmas, das zwischen einem mit den Kontaktnasen in Kontakt stehenden Waferpaar, brennt, um bei Hochfrequenzanwendungen im Bereich der Kontaktanordnung keine übermäßigen Verluste zu erzeugen.

Die Plasma-Behandlungsvorrichtung weist einen Prozessraum zur Aufnahme eines Waferbootes des obigen Typs, Mittel zum Steuern oder Regeln einer Prozessgasatmosphäre in dem Prozessraum und wenigstens eine Spannungsquelle auf, die mit den Platten des Waferbootes in geeigneter Weise verbindbar ist, um zwischen direkt benachbarten Platten des Waferbootes eine elektrische Spannung anzulegen, wobei die wenigstens eine Spannungsquelle geeignet ist wenigstens eine Gleichspannung oder eine Niederfrequenz-Wechselspannung und eine Hochfrequenz-Wechselspannung anzulegen. Hierdurch ist es möglich das Waferboot mit unterschiedlichen Spannungen zu beaufschlagen, um einerseits in einer Aufheizphase mit Gleichspannung oder Niederfrequenz-Wechselspannung die Abstandselemente als Widerstandsheizelemente zu nutzen und andererseits in einer Prozessphase mit Hochfrequenz-Wechselspannung ein Plasma zwischen den Platten zu erzeugen. Für eine rasche Aufheizung des Prozessraums und des darin aufgenommenen Waferbootes ist ferner wenigsten eine Zusatz-Heizeinheit vorgesehen. Der Prozessraum kann sowohl eine horizontale als auch eine vertikale Ausrichtung besitzen.

Bei einem Verfahren zur Plasmabehandlung von Wafern, wird eine Vielzahl von Wafern in einem Waferboot des obigen Typs in den Prozessraum einer Plasma-Behandlungsvorrichtung des obigen Typs aufgenommen. Anschließend wird während einer Aufheizphase eine Gleichspannung oder eine Niederfrequenz-Wechselspannung an die Platten des Waferbootes derart angelegt, dass sich die Abstandselemente aufgrund eines Stromflusses durch sie hindurch erwärmen, und während einer Prozessphase wird eine Hochfrequenz-Wechselspannung an die Platten des Waferbootes angelegt, um zwischen den daran aufgenommenen Wafern ein Plasma zu erzeugen. Hierdurch kann eine kurze Aufheizphase erreicht werden, da die Abstandselemente die Wärme direkt an die inneren Platten respektive die Wafer abgeben können.

Bevorzugt wird die Temperatur in der Prozesskammer gesteuert oder geregelt und die Umschaltung zwischen dem Anlegen der Gleich- oder Niederfrequenz-Wechselspannung und dem Anlegen der Hochfrequenz-Wechselspannung erfolgt, wenn die Temperatur der Wafer eine vorbestimmte Temperatur erreicht oder überschreitet. Bei einer Ausführungsform, bei der mit der Hochfrequenz-Wechselspannung nicht oder nur unwesentlich geheizt werden soll, ist die angelegte Gleich- oder Niederfrequenz-Wechselspannung wesentlich größer als die Hochfrequenz-Wechselspannung, insbesondere um wenigsten einen Faktor 2.

Bevorzugt wird die Gasatmosphäre in der Prozesskammer gesteuert oder geregelt und insbesondere werden während der Aufwärmphase und der Prozessphase unterschiedliche Gasatmosphären eingestellt, die sich sowohl hinsichtlich der Zusammensetzung des Gases als auch hinsichtlich des Drucks unterscheiden können. So wird zum Beispiel während der Aufheizphase ein inertes Gas mit einem ersten Druck und in der Prozessphase ein reaktives Gas bzw. eine reaktive Gasmischung mit einem zweiten Druck, der unter dem ersten Druck liegt, bevorzugt.

Die Erfindung wird nachfolgend unter Bezugnahme auf die Zeichnungen noch näher erläutert; in den Zeichnungen zeigt:
- Fig. 1: eine schematische Seitenansicht eines Waferbootes;
- Fig. 2: eine schematische Draufsicht auf das Waferboot gemäß Fig. 1;
- Fig. 3: eine schematische Vorderansicht des Waferbootes gemäß Fig. 1;
- Fig. 4: eine schematische Ansicht einer Plasma-Behandlungsvorrichtung mit darin aufgenommen Waferboot gemäß Fig. 1;
- Fig. 5: eine Schematische Frontansicht einer Prozesskammer der Plasma-Behandlungsvorrichtung gemäß Fig. 4;
- Fig. 6: eine schematische Draufsicht auf einen Teil einer Gaszuführung der Prozesskammer gemäß Fig. 5;
- Fig. 7: eine Schematische Frontansicht einer alternativen Prozesskammer der Plasma-Behandlungsvorrichtung gemäß Fig. 4;
- Fig. 8: eine Schematische Frontansicht einer weiteren alternativen Prozesskammer der Plasma-Behandlungsvorrichtung gemäß Fig. 4;
- Fig. 9: eine Schematische Frontansicht einer weiteren alternativen Prozesskammer der Plasma-Behandlungsvorrichtung gemäß Fig. 4;
- Fig. 10: eine schematische Seitenansicht eines alternativen Waferbootes, zum Einsatz in einer Plasma-Behandlungsvorrichtung;
- Fig. 11: a bis c schematische Seitenansichten von Teilen des alternativen Waferbootes gemäß Fig. 9, einzeln und in ihrer Endanordnung;
- Fig. 12: eine schematische Draufsicht auf einen Teilbereich des Waferboots gemäß Fig. 9;
- Fig. 13: eine schematische Seitenansicht eines weiteren alternativen Waferbootes, zum Einsatz in einer Plasma-Behandlungsvorrichtung; und
- Fig. 14: eine schematische Seitenansicht eines Teiles des alternativen Waferbootes gemäß Fig. 12;
- Fig. 15: eine schematische Draufsicht auf ein weiteres alternatives Waferboot;
- Fig. 16: eine schematische Seitenansicht eines Teils des Waferbootes gemäß Fig. 15;
- Fig. 17: (a) und (b) schematische Querschnittansichten durch eine Prozesskammer einer Plasma-Behandlungsvorrichtung gemäß Fig. 4 mit einem Waferboot gemäß Fig. 15 darin aufgenommen;
- Fig. 18: eine schematische Draufsicht auf ein weiteres Waferboot;
- Fig. 19: eine schematische Seitenansicht eines Teils des Waferbootes gemäß Fig. 19; und
- Fig. 20: (a) und (b) schematische Querschnittansichten durch eine Prozesskammer einer Plasma-Behandlungsvorrichtung gemäß Fig. 4 mit einem Waferboot gemäß Fig. 18 darin aufgenommen.

In der Beschreibung verwendete Begriffe wie oben, unten, links und rechts beziehen sich auf die Darstellung in den Zeichnungen und sind nicht einschränkend zu sehen. Sie können aber bevorzugte Ausführungen beschreiben. Die Formulierung im Wesentlichen bezogen auf parallel, senkrecht oder Winkelangaben soll Abweichungen von ± 3° umfassen, vorzugsweise ± 2°. Im Nachfolgenden wird der begriff Wafer für scheibenförmige Substrate verwendet, die bevorzugt Halbleiterwafer für Halbleiter-oder Photovoltaikanwendungen sind, wobei aber auch Substrate anderer Materialien vorgesehen und prozessiert werden können,

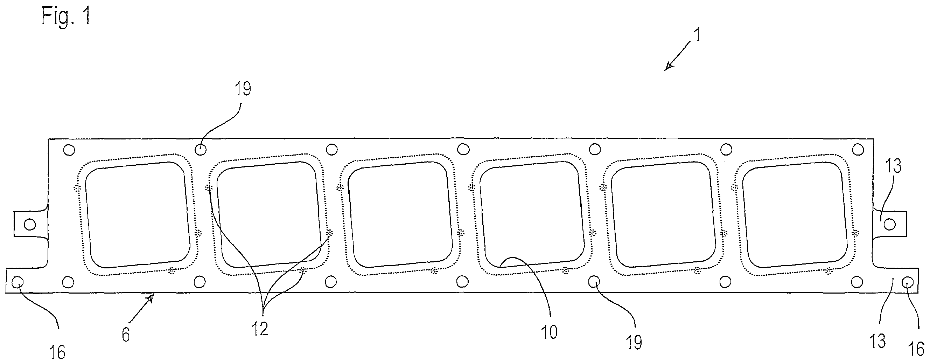

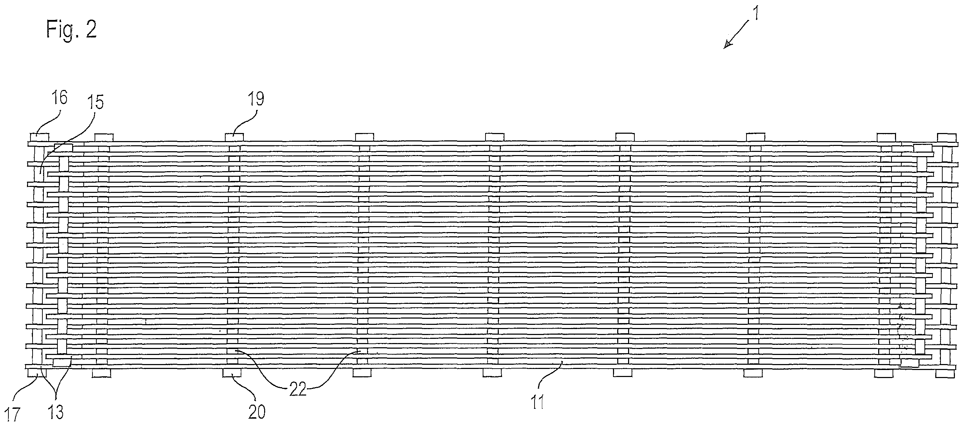

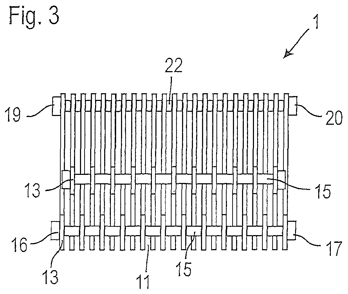

Im Nachfolgenden wird der Grundaufbau eines Waferbootes 1 für den Einsatz in einer Plasma-Behandlungsvorrichtung anhand der Figuren 1 bis 3 näher erläutert, wobei Figur 1 eine schematische Seitenansicht eines Waferbootes 1 zeigt und die Figuren 2 und 3 eine Draufsicht bzw. eine Vorderansicht zeigen. In den Figuren werden dieselben Bezugszeichen verwendet, sofern dieselben oder ähnliche Elemente beschrieben werden.

Das Waferboot 1 wird durch eine Vielzahl von Platten 6, Kontaktierungseinheiten und Spanneinheiten gebildet. Das dargestellte Waferboot 1 ist speziell für eine Schichtabscheidung aus einem Plasma, zum Beispiel von Si₃N₄, SiNₓ, a-Si, Al₂O₃, AlOₓ, dotiertes und undotiertes Poly-Silizium oder amorphes Silizium etc, und insbesondere eine Plasma Nitridierung von Wafern geeignet.

Die Platten 6 bestehen jeweils aus einem elektrisch leitenden Material, und sind insbesondere als Graphitplatten ausgebildet, wobei je nach Prozess eine Beschichtung oder Oberflächenbehandlung des Platten-Grundmaterials vorgesehen sein kann. Die Platten 6 besitzen jeweils sechs Aussparungen 10, die im Prozess von den Wafern abgedeckt sind, wie nachfolgend noch näher erläutert wird. Obwohl bei der dargestellten Form sechs Aussparrungen pro Platte 6 vorgesehen sind, sei bemerkt, dass auch eine größere oder kleinere Anzahl vorgesehen sein kann. Die Platten 6 besitzen jeweils parallele Ober- und Unterkanten, wobei in der Oberkante beispielsweise eine Vielzahl von Kerben ausgebildet sein kann, um einer Lageerkennung der Platten zu ermöglichen, wie in der DE 10 2010 025 483 beschrieben ist.

Bei der dargestellten Ausführungsform sind insgesamt dreiundzwanzig Platten 6 vorgesehen, die über die entsprechende Kontaktiereinheiten und Spanneinheiten im Wesentlichen parallel zueinander angeordnet sind, um dazwischen Aufnahmeschlitze 11 zu bilden. Bei dreiundzwanzig Platten 6 werden somit zweiundzwanzig der Aufnahmeschlitze 11 gebildet. In der Praxis werden jedoch auch häufig 19 oder 21 Platten verwendet, und die Erfindung ist nicht auf eine bestimmte Anzahl von Platten beschränkt.

Die Platten 6 weisen wenigstens jeweils auf ihrer zu einer benachbarten Platte 6 weisenden Seite Gruppen von jeweils drei Aufnahmeelementen 12 auf, die so angeordnet sind, dass sie einen Wafer dazwischen aufnehmen können. Die Gruppen der Aufnahmeelemente 12 sind jeweils um eine jede Aussparungen 10 herum angeordnet, wie schematisch in Fig. 1 angedeutet ist. Die Wafer können derart aufgenommen werden, dass die Aufnahmeelemente jeweils unterschiedliche Seitenkanten des Wafers kontaktieren. Dabei sind in Längsrichtung der Plattenelemente (entsprechend den Ausnehmungen 10) insgesamt jeweils sechs Gruppen von Aufnahmeelementen zum jeweiligen Aufnehmen eines Halbleiterwafers vorgesehen.

An ihren Enden weisen die Platten 6 jeweils eine vorstehende Kontaktnase 13 auf, die für eine elektrische Kontaktierung der Platten 6 dient, wie nachfolgend noch näher erläutert wird. Dabei sind zwei Ausführungsformen von Platten 6 vorgesehen, die sich hinsichtlich der Lage der Kontaktnasen 13 unterscheiden. Bei einer Ausführungsform sind die Kontaktnasen 13 jeweils im direkten Anschluss an die Unterkante ausgeführt, während sie bei der anderen Ausführungsform von der Unterkante beabstandet sind, wobei der Abstand zur Unterkante größer ist als die Höhe der Kontaktnasen 13 der Platten der anderen Ausführungsform. Die zwei Ausführungsformen an Platten 6 werden in dem Waferboot 1 abwechselnd angeordnet. Wie am besten in der Ansicht gemäß Fig. 2 zu erkennen ist, liegen somit die Kontaktnasen 13 von direkt benachbarten Platten 6 in der Anordnung des Waferbootes 1 auf unterschiedlichen Ebenen. Bei jeder zweiten Platte 6 liegen die Kontaktnasen 13 jedoch in derselben Ebene. Hierdurch werden durch die Kontaktnasen 13 zwei beabstandete Kontaktebenen gebildet. Diese Anordnung ermöglicht, dass direkt benachbarte Platten 6 mit unterschiedlichem Potential beaufschlagt werden können, während jede zweite Platte mit demselben Potential beaufschlagt werden kann.

Die in einer jeweiligen Kontaktebene liegenden Kontaktnasen 13 werden über Kontaktblöcke 15 aus einem elektrisch gut leitenden Material, insbesondere Graphit, elektrisch verbunden und mit einem vorbestimmten Abstand zueinander angeordnet. Im Bereich der Kontaktnasen 13 und in jedem der Kontaktblöcke 15 ist jeweils wenigstens eine Durchgangsöffnung vorgesehen. Diese ermöglichen im zueinander ausgerichteten Zustand das Durchführen eines Spannelements 16, das einen Schaftteil (nicht sichtbar) und einen Kopfteil aufweist, wie zum Beispiel einer Schraube, Über ein auf das freie Ende des Schaftteils wirkendes Gegenelement, wie zum Beispiel eine Mutter 17 können die Platten 6 dann zueinander fixiert werden. Hierbei werden die Platten in zwei unterschiedlichen Gruppen zueinander fixiert und zwar derart, dass die Platten der unterschiedlichen Gruppen abwechselnd angeordnet sind. Dabei kann das Spannelement 16 aus elektrisch leitendem Material bestehen was aber nicht notwendig ist. Die Kontaktblöcke 15 besitzen jeweils vorzugsweise dieselbe Länge (in der Richtung, die den Abstand zwischen Kontaktnasen 13 der Platten 6 definiert) und zwar entsprechend der Breite zweier Aufnahmeschlitze 11 plus der Breite einer Platte 6. Die Kontaktblöcke 15 sind bevorzugt so ausgebildet, dass sie eine geringe thermische Masse besitzen und insbesondere sollte die Summe der Kontaktblöcke eine geringere thermische Masse aufweisen als die Summe der Platten 6. Bevorzugt sollte sogar die kombinierte thermische Masse der Summe der Kontaktblöcke und der Summe Kontaktnasen 13 der Platten kleiner sein als die thermische Masse der Summe der Platten 6 abzüglich der thermischen Masse der jeweiligen Kontaktnasen 13.

Ferner sind in den Platten benachbart zur Oberkante und zur Unterkante weitere Durchgangsöffnungen vorgesehen, die jeweils das Durchführen eines Spannelements 19, das einen Schaftteil (nicht sichtbar) und einen Kopfteil aufweist, wie zum Beispiel einer Schraube der Spanneinheit erlauben. Diese können wiederum mit entsprechenden Gegenelementen 20, wie zum Beispiel Muttern zusammenwirken. Bei der dargestellten Ausführungsform sind jeweils sieben Durchgangsöffnungen benachbart zur Oberkante und sieben Durchgangsöffnungen benachbart zur Unterkante vorgesehen. Dabei sind um jede Aussparung 10 jeweils vier Durchgangsöffnungen angeordnet, und zwar annähernd symmetrisch hierzu. Als weiterer Teil der Spanneinheit ist eine Vielzahl von Abstandselementen 22 vorgesehen, die beispielsweise als Abstandshülsen mit im Wesentlichen gleicher Länge ausgebildet sind. Die Abstandselemente 22 sind jeweils im Bereich der jeweiligen Durchgangsöffnungen zwischen direkt benachbarten Platten 6 angeordnet.

Die Schaftteile der Spannelement 19 sind jeweils so bemessen, dass sie sich durch entsprechende Öffnungen aller Platten 6 sowie jeweilige dazwischen befindliche Abstandselemente 22 hindurch erstrecken können. Über das wenigstens eine Gegenelement 20, können dann alle Platten 6 im Wesentlichen parallel zueinander fixiert werden. Es sind jedoch hier auch andere Spanneinheiten mit Abstandselementen 22 denkbar, welche die Platten 6 mit dazwischen befindlichen Abstandselementen 22 im Wesentlichen parallel anordnen und verklemmen. Bei der dargestellten Ausführungsform sind bei 22 Aufnahmeschlitzen und insgesamt 14 Abstandselementen 22 pro Schlitz (sieben benachbart zur Oberkante und sieben benachbart zur Unterkante) 308 Abstandselemente vorgesehen.

Die Spannelemente 19 sind bevorzugt aus einem elektrisch isolierenden Material, während die Abstandselemente 22 bevorzugt aus einem elektrisch leitenden Material bestehen. Insbesondere bestehen die Abstandselemente 22 bevorzugt aus einem hochohmigen Material, derart, dass die Abstandselemente beim Anlegen einer Gleich- oder Niederfrequenzspannung mit ausreichender Amplitude als ein Widerstandselement dienen, jedoch beim Anlegen einer Hochfrequenzspannung (zum Erzeugen eines Plasmas zwischen den Platten) keine wesentliche Dämpfung der Wellenausbreitung vorsehen. Für die Niederfrequenzspannung wird insbesondere ein Frequenzbereich von 50 Hz bis 10 KHz und für die Hochfrequenzspannung ein Bereich über 40 KHz in Betracht gezogen, wobei aber auch andere Frequenzbereiche möglich wären. Bei der dargestellten Ausführung mit der gewählten Verteilung sollte beispielweise jedes Abstandselement einen Widerstand von größer 3 kΩ, insbesondere von größer 20 kΩ oder gar größer 40 kΩ besitzen. Beispielsweise können die Abstandselemente aus dotiertem Silizium, Polysilizium oder einem anderen geeigneten Material bestehen, dass einerseits durch den Prozess nicht beeinträchtigt wird und andererseits den Prozess nicht beeinträchtigt, insbesondere keine Verunreinigungen in den Prozess einbringt. Während über die Kontaktelemente 15 die Platten 6 einer Gruppe (oben liegende Kontaktnase 13/unten liegende Kontaktnase 13) elektrisch verbunden und zueinander fixiert sind über die Abstandselemente 22 alle Platten elektrisch verbunden und zueinander fixiert.

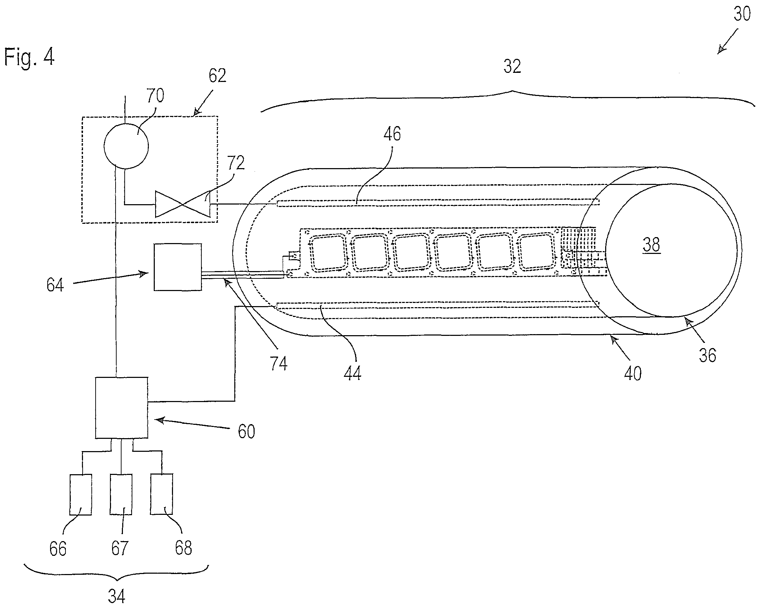

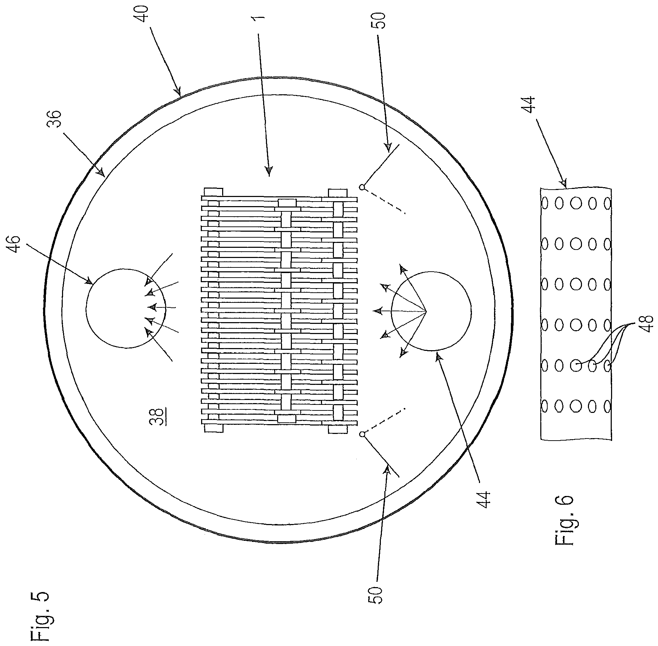

Im Nachfolgenden wird nun der Grundaufbau einer Plasma-Behandlungsvorrichtung 30, in der ein Waferboot 1 des obigen Typs (aber auch ein konventionelles Waferboot) einsetzbar ist, anhand der Figuren 4 bis 6 näher erläutert, wobei Figur 4 eine schematische Seitenansicht der Behandlungsvorrichtung 30, die Figur 5 eine schematische Frontansichten eines Prozesskammeraufbaus und Fig. 6 eine Draufsicht auf eine Gaszuleitung zeigen.

Die Behandlungsvorrichtung 30 besteht aus einem Prozesskammerteil 32 und einem Steuerteil 34. Der Prozesskammerteil 32 besteht aus einem einseitig verschlossenen Rohrelement 36, dass im inneren eine Prozesskammer 38 bildet. Das offene Ende des Rohrelements 36 dient zur Beladung der Prozesskammer 38 und es kann über einen nicht dargestellten Schließmechanismus verschlossen und hermetische abgedichtet werden, wie es in der Technik bekannt ist. Das Rohrelement besteht aus einem geeigneten Material, das in den Prozess keine Verunreinigungen einbringt, elektrisch isoliert ist und den Prozessbedingungen hinsichtlich Temperatur und Druck (Vakuum) standhält, wie zum Beispiel Quarz. Das Rohrelement 36 weist an seinem geschlossenen Ende gasdichte Durchführungen für die Zu- und Ableitung von Gasen sowie Strom auf, die in bekannter Weise ausgebildet sein können. Entsprechende Zu- und Ableitungen könnten aber auch am anderen Ende oder aber auch seitlich an einem geeigneten Ort zwischen den Enden vorgesehen sein.

Das Rohrelement 36 ist von einer Ummantelung 40 umgeben, die das Rohrelement 38 thermisch gegenüber der Umgebung isoliert. Zwischen der Ummantelung 40 und dem Rohrelement 36 ist eine nicht näher dargestellte Heizeinrichtung vorgesehen, wie beispielsweise ein Widerstandsheizer, der geeignet ist das Rohrelement 36 aufzuheizen. Eine solche Heizeinrichtung kann aber zum Beispiel auch im Inneren des Rohrelements 36 vorgesehen sein oder das Rohrelement 36 selbst könnte als Heizeinrichtung ausgebildet sein. Derzeitig wird aber eine außen liegende Heizeinrichtung bevorzugt und insbesondere eine solche, die verschiedene, individuell ansteuerbare Heizkreise aufweist.

Im inneren des Rohrelements 36 sind nicht näher dargestellte Aufnahmeelemente vorgesehen, die eine Aufnahmeebene zur Aufnahme eines Waferbootes 1 (das in Fig. 4 nur teilweise gezeigt ist), das beispielsweise des obigen Typs sein kann, bilden. Das Waferboot kann aber auch derart in das Rohrelement 36 eingesetzt werden, dass es auf der Wand des Rohrelements 36 aufsteht. Dabei wird das Waferboot im Wesentlichen oberhalb der Aufnahmeebene gehalten und ist ungefähr mittig im Rohrelement angeordnet, wie beispielsweise in der Frontansicht der Fig. 5 zu erkennen ist. Durch entsprechende Aufnahmeelemente und oder ein direktes Aufsetzen auf das Rohrelement wird somit in Kombination mit den Abmessungen des Waferbootes ein Aufnahmeraum definiert, in dem sich ein ordnungsgemäß eingesetztes Waferboot befindet. Das Waferboot kann über einen geeigneten nicht dargestellten Handhabungsmechanismus als ganzes im beladenen Zustand in die Prozesskammer 38 hinein und aus dieser heraus gehandelt werden. Dabei wird bei einer Beladung des Waferbootes automatisch ein elektrischer Kontakt mit jeweils wenigstens einem Kontaktblock 15 jeder der Gruppen von Platten 6 hergestellt, wie nachfolgend noch näher erläutert wird.

Im Inneren des Rohrelements 36 sind ferner ein unteres Gasführungsrohr 44 und ein oberes Gasführungsrohr 46 vorgesehen, die aus einem geeigneten Material wie beispielsweise Quarz bestehen. Die Gasführungsrohre 44, 46 erstrecken sich in Längsrichtung des Rohrelements 36 und zwar wenigstens über die Länge des Waferbootes 1. Die Gasführungsrohre 44, 46 besitzen jeweils einen runden Querschnitt und sind jeweils in Querrichtung ungefähr mittig unter bzw. oberhalb des Waferbootes 1 angeordnet. Die Gasführungsrohre 44, 46 stehen an Ihrem näher zum geschlossenen Ende des Rohrelements 36 liegenden Ende mit einer Gaszuführeinheit bzw. einer Gasabführeinheit in Verbindung, wie nachfolgend noch näher erläutert wird. Das jeweils entgegengesetzte Ende der Gasführungsrohre 44, 46 ist verschlossen. Es ist aber grundsätzlich auch eine kurze Gasführung denkbar, bei der zum Beispiel nur an einem Ende des Rohrelements Gas eingelassen wird und sich über Diffusion verteilt und/oder über eine Vakuumanschluss (bevorzugt am Gegenüberliegenden Ende des Rohrelements 36) gepumpt wird.

Das untere Gasführungsrohr 44 besitzt eine Vielzahl von Öffnungen 48, durch die Gas aus dem Gasführungsrohr austreten kann. Die Öffnungen befinden sich alle in einer oberen Hälfte des Gasführungsrohrs, sodass ein hieraus austretendes Gas eine nach oben gerichtete Komponente aufweist. Insbesondere wird in Betracht gezogen eine Vielzahl von sich quer zur Längserstreckung des Gasführungsrohrs 44 erstreckenden Reihen von Öffnungen 48 vorzusehen, wobei jeder Reihe beispielsweise fünf Öffnungen 48 aufweist. In der Draufsicht gemäß Fig. 6 ist ein Abschnitt eines entsprechenden Gasführungsrohrs 44 schematisch dargestellt. Die Öffnungen sollten in einem Bereich in Längsrichtung des Gasführungsrohrs 44 ausgebildet sein, der wenigstens eine Länge besitzt, die der Länge des Waferbootes entspricht. Bevorzugt besitzt der Bereich eine größere Länge als das Waferboot und ist so angeordnet, dass der Bereich über die Enden des Waferbootes hinaus geht. Bevorzugt ist die Summe der Fläche der Öffnungen 48 kleiner als die Querschnittsfläche des Gasführungsrohrs 44. Bevorzugt liegt das Verhältnis der Summe der Fläche der Öffnungen 48 zur Querschnittsfläche des Gasführungsrohrs 44 zwischen 30 und 70% und insbesondere zwischen 40 und 60%. Bei einer Beaufschlagung mit einem Gas stellt sich dann ein konstanter Druck im Gaszuleitungsrohr 44 ein und es kann eine gleichmäßige Gasverteilung über den mit Öffnungen versehenen Bereich erreicht werden. Insbesondere wird ein Abstand der Reihen der Öffnungen 48 von ungefähr 5 mm bei einem Öffnungsdurchmesser von ungefähr 1,5 mm in Betracht gezogen. Dabei wird der Abstand zwischen den Mittelpunkten der jeweiligen Öffnungen der unterschiedlichen Reihen gemessen. Der Abstand kann aber auch unterschiedlich gewählt werden und insbesondere bei geringeren Drücken könnte die Abstand größer werden. Bevorzugt sollte der Abstand kleiner als 5 cm, bevorzugt kleiner 2 cm und insbesondere kleiner als 1 cm sein.

Das obere Gasführungsrohr 46 besitzt einen ähnlichen Aufbau mit Öffnungen, wobei hier die Öffnungen in der unteren Hälfte ausgebildet sind. Im Wesentlichen können die Gasführungsrohre 44, 46 identisch, jedoch in einer jeweils anderen Orientierung angeordnet sein, sodass die Öffnungen jeweils zum Waferboot 1 zeigen. Somit weisen sowohl die Öffnungen im unteren Gasführungsrohr 44 als auch im oberen Gasführungsrohr 46 zu dem Aufnahmeraum, d.h. dem Bereich in dem ein ordnungsgemäß eingesetztes Waferboot angeordnet wird. Statt Reihen mit jeweils fünf Öffnungen vorzusehen, ist es auch möglich eine unterschiedliche Anordnung oder auch unterschiedliche Formen der Öffnungen, beispielsweise Schlitze, vorzusehen.

Über solche Gasführungsrohre 44, 46 kann eine gute homogene Gasverteilung innerhalb der Prozesskammer erreicht werden, insbesondere auch in den Aufnahmeschlitzen 11 des Waferbootes. Hierzu wird beispielsweise bevorzugt das untere Gasführungsrohr mit Gas beaufschlagt, während entsprechend über das oberer Gasführungsrohr 46 Gas abgesaugt wird. Das untere Gasführungsrohr 44 sorgt für eine gute Verteilung von Gas unterhalb des Waferbootes, und die Absaugung am oberen Gasführungsrohr 46 sorgt dafür, dass das Gas zwischen den Platten 6 des Waferbootes 1 nach oben transportiert wird.

Um diesen Effekt zu verstärken, d.h. den Gasstrom insbesondere zwischen die Platten 6 des Waferbootes zu lenken, sind im Prozessraum zwei optionale, bewegliche Umlenkelemente 50 vorgesehen. Die Umlenkelemente 50, die in der Fig. 4 zur Vereinfachung der Darstellung nicht dargestellt sind, besitzen eine langgestreckte Konfiguration. Die Umlenkelemente 50 erstrecken sich in Längsrichtung des Prozessrohrs 36 und besitzen bevorzugt eine Länge die wenigstens der Länge des Waferbootes entspricht. Bevorzugt sollten die Umlenkelemente 50 jedoch eine Länge besitzen, die wenigstens der Länge des Bereichs des unteren Gasführungsrohrs 44 entspricht, in dem die Öffnungen 48 ausgebildet sind. Die Umlenkelemente 50 sind unterhalb und in Querrichtung seitlich zum Waferboot 1 in der Prozesskammer 38 angeordnet. An ihrem oberen Ende sind die Umlenkelemente 50 jeweils drehbar gelagert und können über einen nicht dargestellten Einstellmechanismus zwischen einer ersten Position, die in den Figuren 5 und 7 bis 9 mit einer durchgezogenen Linie gezeigt ist, und einer zweiten Position, die in den Figuren 5 und 7 bis 9 mit einer gestrichelten Linie gezeigt ist, bewegt werden. In der ersten Position verhindern die Umlenkelemente im Wesentlichen eine Gasströmung seitlich um das Waferboot herum, während eine solche in der zweiten Position erlaubt wird.

Der Einstellmechanismus kann zum Beispiel ein auf den Druck in der Prozesskammer 38 ansprechender Mechanismus sein, der die Umlenkelemente 50 beispielsweise automatisch bei einem bestimmten Unterdruck in der Prozesskammer 38 in die erste Position bringt. Es sind aber auch andere Einstellmechanismen, die mechanisch oder elektrisch betätigt werden denkbar, wobei für solche dann entsprechende Zuleitungen für die Steuerung vorgesehen sein müssen.

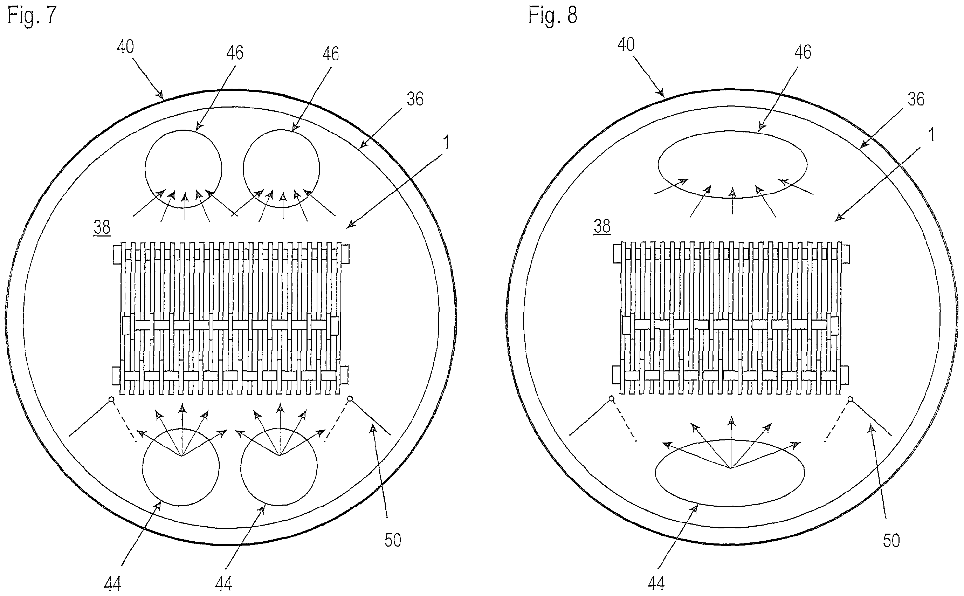

Die Figuren 7 bis 9 zeigen schematische Frontansichten alternativer Prozesskammeraufbauten, die sich lediglich hinsichtlich der Form und/oder Anzahl der Gasführungsrohre unterscheiden. Bei der Ausführungsform gemäß Fig. 7 sind jeweils zwei untere und zwei obere Gaszuführungsrohre 44, 46 vorgesehen. Die unteren Gasführungsrohre 44 ,44 liegen in einer horizontalen Ebene unterhalb des Waferbootes 1 und sind symmetrisch bezüglich einer vertikalen Mittelebene der Prozesskammer angeordnet. Hinsichtlich der Öffnungen können sie gleich zu dem oben beschriebenen Gasführungsrohr aufgebaut und angeordnet sein. Die oberen Gasführungsrohre 46 ,46 liegen in einer horizontalen Ebene oberhalb des Waferbootes 1 und sie sind ebenfalls symmetrisch bezüglich einer vertikalen Mittelebene der Prozesskammer angeordnet. Insbesondere können bei dieser oder einer ähnlichen Anordnung mit mehreren unteren Gasführungsrohren für die Gaszuleitung über die unterschiedlichen Gasführungsrohre unterschiedliche Gase in die Prozesskammer 38 eingeleitet werden, die sich somit erst in der Prozesskammer vermischen, um einer vorzeitige Reaktion innerhalb der Gaszuführung zu vermeiden.

Bei der Ausführungsform gemäß Fig. 8 ist jeweils wiederum nur ein unteres und ein oberes Gasführungsrohr 44, 46 vorgesehen. Die Gasführungsrohre 44, 46 besitzen jeweils eine elliptische Querschnittsform, wobei die jeweiligen Hauptachsen horizontal angeordnet sind. Die Gasführungsrohre 44, 46 liegen wiederum mittig unter- bzw. oberhalb des Waferbootes 1. Mit anderen Worten sind sie symmetrisch bezüglich einer vertikalen Mittelebene der Prozesskammer angeordnet. Hinsichtlich der Öffnungen können sie im Wesentlichen gleich den oben beschriebenen Gasführungsrohren aufgebaut und angeordnet sein.

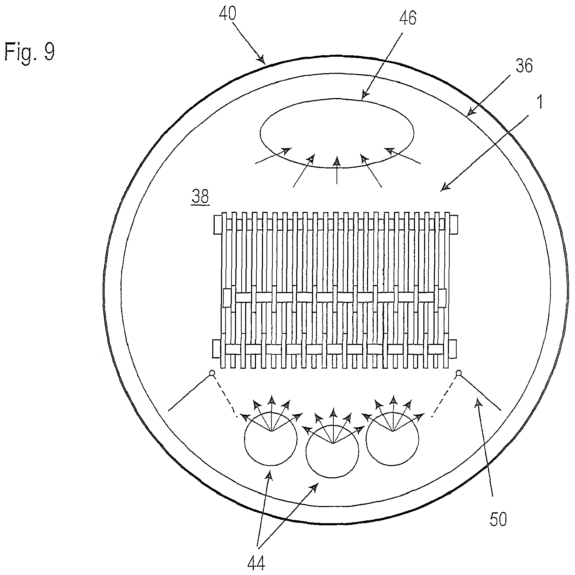

Bei der Ausführungsform gemäß Fig. 9 sind drei untere Gaszuführungsrohre 44 sowie ein einzelnes oberes Gaszuführungsrohr 46 vorgesehen. Die unteren Gasführungsrohre 44 liegen unterhalb des Waferbootes 1, wobei die zwei Äußeren in einer Ebene liegen während das mittlere etwas nach unten versetzt ist. Es wäre aber auch eine andere Anordnung möglich. Hinsichtlich der Öffnungen können sie gleich zu dem oben beschriebenen Gasführungsrohr aufgebaut und angeordnet sein. Das obere Gasführungsrohr 46 liegt oberhalb des Waferbootes 1 und besitzt eine elliptische Querschnittsform, wie bei Fig. 8 und ist symmetrisch bezüglich einer vertikalen Mittelebene der Prozesskammer angeordnet. Alternativ könnten auch hier mehrere Gasführungsrohre oder eine andere Form des Gasführungsrohrs vorgesehen werden. Insbesondere können bei dieser oder einer ähnlichen Anordnung mit mehreren unteren Gasführungsrohren für die Gaszuleitung über die unterschiedlichen Gasführungsrohre unterschiedliche Gase in die Prozesskammer 38 eingeleitet werden, die sich somit erst in der Prozesskammer vermischen, um einer vorzeitige Reaktion innerhalb der Gaszuführung zu vermeiden. Insbesondere können bei dieser Anordnung über die äußeren Gasführungsrohre 44 ein erstes Gas eingeleitet werden, während über das mittlere ein zweites Gas eingeleitet wird. Die Anordnung ermöglicht eine gute und homogene Vermischung und Verteilung der Gase.

Nachfolgend wird nun der Steuerteil 34 der Behandlungsvorrichtung 30 näher erläutert. Der Steuerteil 34 weist eine Gassteuereinheit 60, Unterdruck-Steuereinheit 62, eine elektrische Steuereinheit 64 und eine nicht näher dargestellte Temperatursteuereinheit auf, die alle gemeinsam über eine übergeordnete Steuerung, wie beispielsweise einen Prozessor angesteuert werden können. Die Temperatursteuereinheit steht mit der nicht dargestellten Heizeinheit in Verbindung, um primär die Temperatur des Rohrelements 36 bzw. der Prozesskammer 38 zu steuern bzw. zu regeln.

Die Gassteuereinheit 60 steht mit einer Vielzahl von unterschiedlichen Gasquellen 66, 67, 68, wie beispielweise Gasflaschen, die unterschiedliche Gase enthalten in Verbindung. In der dargestellten Form sind drei Gasquellen dargestellt, wobei natürlich auch eine beliebige andere Anzahl vorgesehen sein kann. Beispielsweise können die Gasquellen Di-Chlorsilan, Tri-Chlorsilan, SiH₄, Phosphin, Boran, Di-Boran, German (GeH4), Ar, H₂, TMA NH₃, N₂ und verschiedene andere Gase an entsprechenden Eingängen der Gassteuereinheit 60 bereitstellen. Die Gassteuereinheit 60 besitzt zwei Ausgänge, wobei einer der Ausgänge mit dem unteren Gasführungsrohr 44 verbunden ist und der Andere mit einer Pumpe 70 der Unterdruck-Steuereinheit 62. Die Gassteuereinheit 60 kann die Gasquellen in geeigneter Weise mit den Ausgängen verbinden und den Durchfluss von Gas Regeln, wie es in der Technik bekannt ist. Somit kann die Gassteuereinheit 60 insbesondere über das untere Gasführungsrohr 44 unterschiedliche Gase in die Prozesskammer einleiten, wie nachfolgend noch näher erläutert wird.

Die Unterdruck-Steuereinheit 62 besteht im Wesentlichen aus der Pumpe 70 und einem Druck-Regelventil 72. Die Pumpe 70 ist über das Druck-Regelventil 72 mit dem oberen Gasführungsrohr 46 verbunden und kann hierüber die Prozesskammer auf einen vorbestimmten Druck abpumpen. Die Verbindung von der Gassteuereinheit 60 zur Pumpe dient dazu aus der Prozesskammer abgepumptes Prozessgas gegebenenfalls mit N₂ zu verdünnen.

Die elektrische Steuereinheit 64 weist wenigstens eine Spannungsquelle auf, die geeignet an einem Ausgang derselben wenigstens eine der Folgenden bereitzustellen, eine Gleichspannung, eine Niederfrequenzspannung und eine Hochfrequenzspannung. Der Ausgang der elektrischen Steuereinheit 64 steht über eine Leitung mit einer Kontaktiereinheit für das Waferboot in der Prozesskammer in Verbindung. Die Leitung ist über eine entsprechende vakuum- und temperaturtaugliche Durchführung durch die Ummantelung 40 und in das Rohrelement 36 eingeführt. Dabei ist die Leitung insbesondere so aufgebaut, dass sie als Koaxialleitung 74 mit einem Innenleiter und einem Außenleiter ausgebildet ist. Über die Länge der Koaxialleitung 74 herrscht außen näherungsweise Feldfreiheit, sodass selbst bei hohen Frequenzen im MHz-Bereich keine parasitären Plasmen entstehen und eine möglichst verlustfreie Übertragung erfolgt. Im Inneren der Koaxialleitung findet eine Wellenausbreitung mit der Wellenlänge λ statt. Die Wellenausbreitung setzt sich zwischen Plattenpaaren (planarer Wellenleiter) fort, jedoch mit einer anderen Wellenlänge, die von dem Vorhandensein und der Art des Plasmas abhängt. Zwischen den Leitern ist ein geeignetes Dielektrikum vorgesehen, welches bei einer Beaufschlagung mit hochfrequenter Spannung die Ausbreitungsgeschwindigkeit und die Wellenlänge der elektromagnetischen Welle im Koaxialleiter gegenüber einer entsprechenden Ausbreitungsgeschwindigkeit und Wellenlänge der elektromagnetischen Welle im Vakuum vermindert. Die Verminderung der Ausbreitungsgeschwindigkeit und der Wellenlänge der elektromagnetischen Welle im Koaxialleiter gegenüber einer entsprechenden Ausbreitungsgeschwindigkeit und Wellenlänge der elektromagnetischen Welle im Vakuum ist äquivalent zu einer der Erhöhung der effektiven elektrischen Länge des Koaxialleiters 74 bezogen auf Vakuumwellenlänge. Insbesondere für eine Impedanztransformation wegen der niedrigen Impedanz des Waferbootes 1 sollte die geometrische Länge des Koaxialleiters nahe eines ungeradzahligen Vielfachen von λ/4 der durch das Dielektrikum verminderten Wellenlänge liegen oder anders ausgedrückt, die effektive elektrische Länge des Koaxialleiters nahe eines ungeradzahligen Vielfachen von λ/4 der Wellenlänge der beaufschlagten Frequenz eingestellt werden.

Bei einer Ausführungsform erfolgt eine Einstellung der Wellenlänge bzw. der elektrischen Länge des Koaxialleiters 74 über eine Vielzahl von Isolatoren, die in den Zwischenraum zwischen Innen- und Außenleiter einführbar sind und so das Dielektrikum bilden. Auch über die Geometrie von Innen- und Außenleiter lässt sich eine gewisse Einstellung vornehmen. Obwohl die Innen- und Außenleiter von Koaxialleitern in der Regel einen runden Querschnitt besitzen, soll der Begriff Koaxialleiter, wie er in der vorliegenden Anmeldung verwendet wird auch Innen- und/oder Außenleiter mit anderen Querschnitten umfassen. Zum Beispiel können die Innen- und/oder Außenleiter rechteckige oder ovale Querschnitte aufweisen und sich entlang einer gemeinsamen Längsachse erstrecken. Die lokale Ausbreitungsgeschwindigkeit der hochfrequenten Welle und damit auch integral die effektive elektrische Länge des Koaxialleiters 74 hängt aber wesentlich vom Dielektrikum zwischen Innen- und Außenleiter ab. Mit steigender Dielektrizitätskonstante nimmt die Ausbreitungsgeschwindigkeit mit 1/(εᵣ)^{1/2} ab und dementsprechend die effektive elektrische Länge der Koaxialleiters 74 zu. Dabei kann durch eine geeignete Aneinanderreihung von kurzen Isolatorstücken unterschiedlicher Dielektrizitätskonstante über die Länge eine gewünschte mittlere Dielektrizitätskonstante eingestellt werden. Die Isolatorstücke können eine den Innen- und Außenleitern entsprechende Form, wie zum Beispiel eine Ringform aufweisen, welche ein aufschieben auf den Innenleiter erlaubt. Die Koaxialleitung 74 führt im Wesentlichen bis zu den Kontaktbereichen des Waferbootes 1. Die Innen- und Außenleiter werden in geeignete Weise mit den unterschiedlichen Gruppen der Platten 6 verbunden.

Die Wellenausbreitung zwischen den Plattenpaaren beeinflusst die Eigenschaften des abscheidenden Plasmas, zum Beispiel in der Homogenität/Uniformität über den Wafer und das Waferboot.

Hierbei sollten die Kontaktnasen 13 des Waferbootes 1 für die Einkopplung hochfrequenten Leistung möglichst in Masse und Länge reduziert werden, um die lokale Wärmekapazität und die Zuleitungsinduktivität so gering wie möglich zu halten. Insbesondere sollte die durch die Summe der Kontaktnasen 13 in Kombination mit den Kontaktelementen 15 gebildete Zuleitungsinduktivität wesentlich kleiner sein als die Induktivität der Summe der Platten 6. Bevorzugt sollte die Impedanz der entsprechenden Zuleitungsinduktivität bei der Betriebsfrequenz kleiner sein als die Hälfte und bevorzugt kleiner als 1/10 der Impedanz des Plattenstapels der Platten 6.

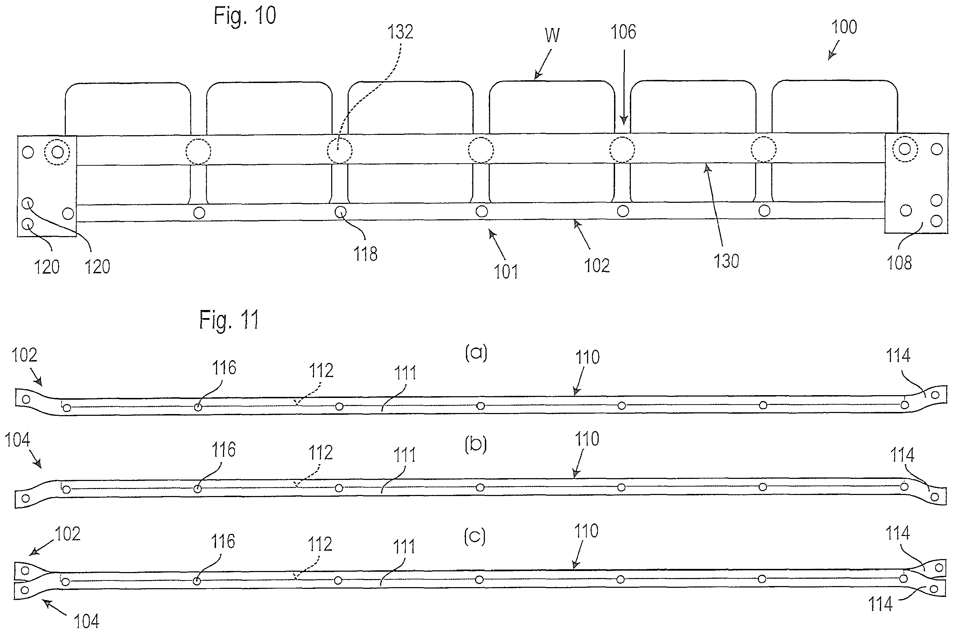

Die Figuren 10 bis 12 zeigen ein alternatives Waferboot 100, dass in einer Plasma-Behandlungsvorrichtung 30 des obigen Typs aber auch in klassischen Plasma-Behandlungsvorrichtungen eingesetzt werden können. Das Waferboot 100 wird durch eine elektrisch leitende Auflageeinheit 101 mit einer Vielzahl von elektrisch leitenden Auflagen 102, 104, beispielsweise aus Graphit oder einem anderen elektrisch gut leitendem Material, eine isolierte Führungseinheit 106 gebildet. Die Auflageeinheit 101 und die isolierte Führungseinheit 106 sind über isolierte Verbindungselemente 108 verbunden und bilden so gemeinsam das Waferboot 100.

Die elektrisch leitenden Auflagen 102, 104 sind am besten in den schematischen Seitenansichten der Figuren 11a bis 11c zu erkennen. Dabei zeigt Fig. 11a eine schematische Seitenansicht der Auflage 102, Fig. 11b eine schematische Seitenansicht der Auflage 104 und Fig. 11c eine schematische Seitenansicht der Auflagen 102, 104 in einer Endanordnung.

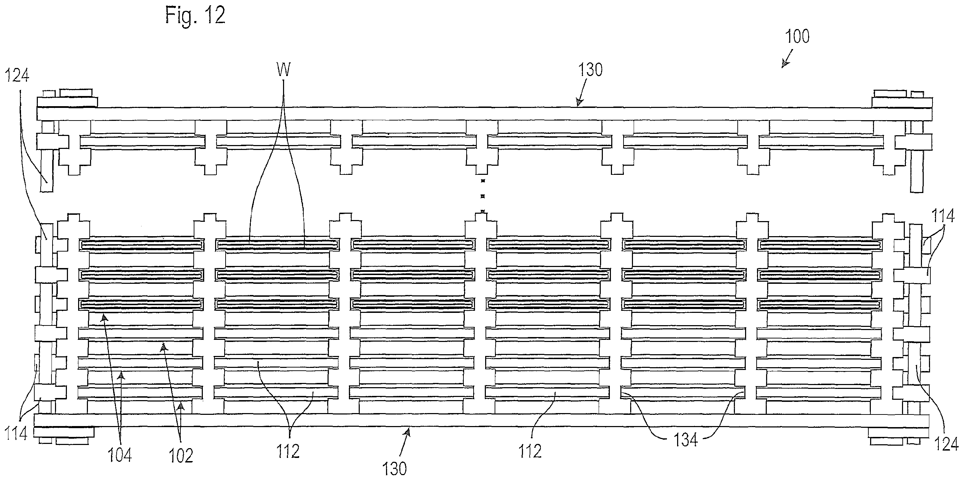

Die Auflagen 102, 104 besitzen jeweils eine langgestreckten Grundkörper 110 mit einer im Wesentlichen rechteckigen Querschnittsform. Der Grundkörper 110 weist jeweils einen geraden Mittelteil auf, in dessen Oberseite ein Schlitz 112 zur Aufnahme von Wafern (W) ausgebildet ist. In Längsrichtung ist der Schlitz 112 so bemessen, dass er sechs Wafer (W) nebeneinander mit einem vorgegebenen Abstand aufnehmen kann, wie in Fig. 10 zu erkennen ist. Die Schlitztiefe ist so gewählt, dass sie kleiner oder gleich einem üblichen Randausschluss bei der Waferherstellung entspricht und liegt somit bei ungefähr 1-5mm. Die Breite des Schlitzes ist wiederum so gewählt, dass zwei zu prozessierende Wafer (W) Back-to-Back darin aufgenommen werden können, wie in der Draufsicht gemäß Fig. 12 angedeutet ist. Der Schlitz 112 kann Quer zur Längsrichtung um 1° bis 2° geneigt sein, sodass ein darin aufgenommenes Waferpaar leicht geneigt in dem Schlitz 112 steht. An Ihren Längsenden (benachbart zu dem den Schlitz 112 aufweisenden Mittelteil 111) besitzen die jeweiligen Grundkörper 110 Endteile 114, die bezüglich des Mittelteils 111 in der Ebene nach oben bzw. nach unten versetzt sind. Dabei sind die Endteile 114 der Auflage 102 nach oben versetzt und die Endteile 114 der Auflage 104 nach unten, wie in den Figuren 11a und 11b gut zu erkennen ist. Wenn sich die Auflagen 102, 104 in Ihrer Endanordnung befinden, liegen die Endteile 114 der Auflagen 102 in einer oberen Ebene und die Endteile 114 der Auflagen 104 in einer unteren Ebene, wie in Fig. 11c zu erkennen ist.

In den Grundkörpern 110 ist jeweils eine Vielzahl von Querbohrungen 116 vorgesehen, die für die Durchführung von Spannelementen 118, bzw. 120 dienen. Diese Können des oben beschriebenen Typs sein mit Kopf und Schaftteil sein, die mit Gegenelementen zusammenwirken können. Während die Spannelemente 118 im Mittelbereich 111 eingesetzt werden, werden die Spannelemente 120 im Bereich der Endteile 114 eingesetzt.

In Ihrer Endanordnung sind eine Vielzahl von beispielsweise 22 der Auflagen 102, 104 quer zu Ihrer Längserstreckung parallel zueinander angeordnet, wobei sich die Auflagen 102 und 104 in der Anordnung abwechseln. Im Mittelbereich 111 der Auflagen 102, 104 sind zwischen direkt benachbarten Auflagen 102, 104 jeweils Abstandshalter (nicht dargestellt) vorgesehen, die mit den Querbohrungen 116 ausgerichtet sind. Diese Abstandshalter sind hülsenförmig und sind so dimensioniert, dass sie im Montagezustand des Waferbootes 100 auf den Schaftteil des Spannelements 118 gesteckt sind. Die Abstandshalter können elektrisch isolierend sein oder aber auch elektrisch leitend, wie die oben beschriebenen Abstandselemente 22 des Waferbootes 1, sofern ihnen einen ähnliche Heizfunktion zukommen soll.

Im Bereich der Endteile 114 sind jeweils elektrisch leitende Hülsen 124 vorgesehen, die so bemessen sind, dass sie auf den Schaftteil eines der Spannelemente 120 gesteckt werden können. Die Hülsen 124 besitzen jeweils eine Länge entsprechen der Länge von zwei Abstandshaltern plus der Breite einer Auflage. Somit sind sie in der Lage jeweils zwei Auflagen 102, 102 oder 104, 104 in der Anordnung elektrisch zu verbinden. Somit bilden die Auflagen 102 eine erste Gruppe von Auflagen die jeweils alle elektrisch verbunden sind und die Auflagen 104 eine zweite Gruppe von Auflagen die jeweils alle elektrisch verbunden sind. Dies ermöglicht wiederum das Anlegen eine Spannung zwischen den unterschiedlichen Gruppen, wie auch beim Waferboot 1.

Die Führungseinheit 106 wird durch zwei langgestreckte Halteelemente 130 und sieben Führungsstangen 132 gebildet, die jeweils aus einem dielektrischen Material bestehen. Die Halteelemente 130 und die Führungsstangen 132 können beispielsweise aus Keramik oder Quarz bestehen. Die Halteelemente 130 besitzen jeweils eine langgestreckte Konfiguration mit einer Länge die im Wesentlichen gleich der Länge der Auflagen 102, 104 ist und sie erstrecken sich im Wesentlichen parallel zu den Auflagen 102, 104, wobei die Halteelemente 130 höher angeordnet sind, als die Auflagen 102, 104. Die Führungsstangen 132 erstrecken sich senkrecht zwischen den Halteelementen 130, wie in der Draufsicht gemäß Fig. 12 zu erkennen ist und sind in geeigneter Weise mit diesen verbunden. Die Führungsstangen 132 können einen kreisförmigen Querschnitt besitzen, wobei aber auch andere Formen möglich sind. Die Führungsstangen 132 besitzen jeweils eine Vielzahl von Einkerbungen 134, die so dimensioniert sind, dass sie einen Randbereich von Waferpaaren W, W, insbesondere einen Randausschussbereich derselben aufnehmen und führen können. In Längsrichtung des Waferbootes 100 sind die Führungsstangen 132 so beabstandet, dass sie jeweils ein Waferpaar W, W dazwischen aufnehmen können, wie in Fig. 12 angedeutet ist. Dabei sei bemerkt, dass die Draufsicht gemäß Fig. 12 das Waferboot 100 nicht vollständig zeigt und das Waferboot zur Vereinfachung der Darstellung nur teilweise beladen ist. Die Einkerbungen 134 sind in Querrichtung des Waferbootes 100 mit den Schlitzen 112 in den Auflagen 102, 104 ausgerichtet. Sofern die Schlitze 112 eine Neigung aufweisen sind die Einkerbungen 134 entsprechend leicht versetzt zu den Schlitzen 112, um eine Aufnahme der Waferpaare W, W in einer leicht geneigten Stellung zu erlauben.

Die Auflageeinheit 101 bestehend aus den verbundenen Auflagen 102, 104 und die isolierte Führungseinheit 106 bestehend aus den Halteelementen 130 und den Führungsstangen 132 sind in den Endbereichen jeweils über isolierte Verbindungselemente 108 verbunden, Insbesondere besitzen die Verbindungselemente 108 jeweils eine Plattenform und sie arbeiten mit den Spannelementen 118 und 120 sowie zusätzlichen Spannelementen für die Verbindung mit dem Haltelement 130 zusammen, um die Anordnung insgesamt zu fixieren und so das Waferboot 100 zu bilden.

Das Waferboot 100 kann in der gleichen Weise wie ein klassisches Waferboot eingesetzt werden, oder auch in der nachfolgend beschriebenen Form, wenn die Abstandshalter elektrisch leitend sind, wie die Abstandselemente 22 beim Waferboot 1. Eine elektrische Kontaktierung der auf den Auflagen 102, 104 aufgenommen Waferpaare W, W erfolgt nur im Bereich der jeweiligen Schlitze 112. Das Waferboot 100 nimmt die Wafer nicht zwischen Platten, sondern lässt diese im Wesentlichen frei stehen. Hierdurch kann eine Aufheizung der Wafer verbessert werden. Diese wird ferner auch durch eine verringerte thermische Masse des Waferbootes 100 im Vergleich zum Waferboot 1 gefördert. Die Back-to-Back Anordnung der Waferpaare kann zu verbesserter Slipfreiheit von prozessierten Wafern beitragen, Ferner können hierdurch gegebenenfalls die Querabmessungen des Waferbootes bei gleicher Aufnahmekapazität verringert werden.

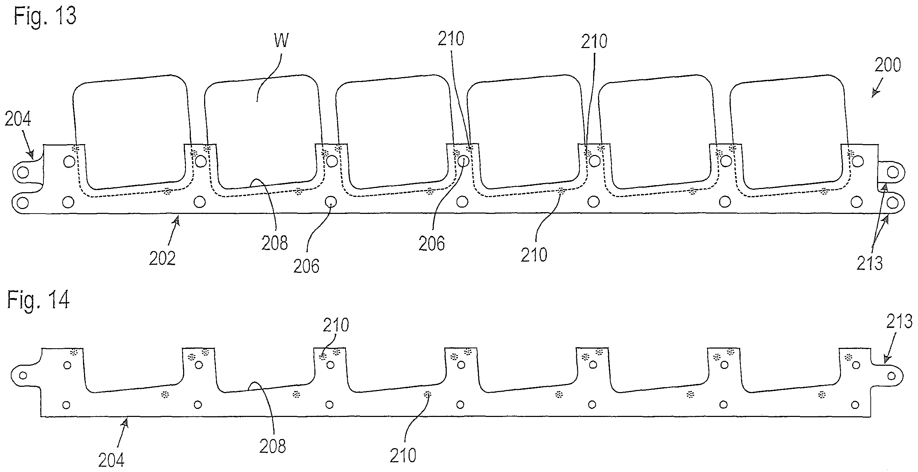

Anhand der Figuren 13 und 14 wird nun eine weitere alternative Ausführungsform eines Waferbootes 200 näher erläutert. dass in einer Plasma-Behandlungsvorrichtung 30 des obigen Typs aber auch in klassischen Plasma-Behandlungsvorrichtungen eingesetzt werden kann. Dabei zeigt Fig. 13 eine schematische Seitenansicht eines beladenen Waferbootes und Fig. 14 eine schematische Seitenansicht einer einzelnen Platte des Waferbootes. Das Waferboot 200 wird im Wesentlichen durch elektrisch leitende Platten 202, 204 beispielsweise aus Graphit oder einem anderen elektrisch gut leitendem Material gebildet, die abwechselnd parallel zueinander über nicht näher dargestellte Abstandshalter und Spannelemente 206 angeordnet werden. Dies kann in der oben beschriebenen Art und Weise erfolgen, wobei die Abstandshalter aus einem dielektrischen Material oder auch einem hochohmigen elektrisch leitenden Material sein können, und zwar je nach dem ob sie eine Zusatzheizfunktion besitzen sollen oder nicht, wie nachfolgend erläutert wird.

Die Platten 202, 204 besitzen jeweils nach oben offene Ausnehmungen 208. Auf beiden Seiten der Platten 202, 204 ist im Bereich jeder Ausnehmung jeweils eine Gruppe von drei Aufnahmestiften 210 vorgesehnen, die für aufzunehmende Wafer W eine Dreipunktanlage bieten. Dabei ist jeweils einer der Aufnahmestifte unterhalb der Ausnehmung 208 und die anderen beiden Aufnahmestifte befinden sich auf gegenüberliegenden Seiten der Ausnehmung 208 und zwar höher als der untere Aufnahmestift 210. Der Höhenabstand zwischen dem unteren Aufnahmestift 210 und der Oberkante der jeweiligen Platten 202, 204 ist kleiner als die halbe Höhe eines aufzunehmenden Wafers W. Anders als beim Waferboot 1 sind aufgenommenen Wafer somit nicht vollständig zwischen zwei Platten aufgenommen, sondern sie stehen nach oben deutlich über die Platten hinaus, wie in Fig. 13 zu erkennen ist. Im Vergleich zu dem Waferboot 1 kann das Waferboot 200 somit eine wesentlich reduzierte thermische Masse aufweisen.

Die Platten 202, 204 weisen an Ihren Enden jeweils Kontaktnasen 213 auf, wobei die Kontaktnasen 213 der beiden Platten wiederum auf unterschiedlichen Höhen liegen, um über elektrisch leitende Kontaktelemente (nicht gezeigt) wiederum eine gruppenweise Kontaktierung der Platten zu ermöglichen. Die Kontaktnasen sind bevorzugt kurz gehalten und sind nach außen hin abgerundet, können aber auch andere Formen aufweisen. Darüber hinaus ist der Abstand in Höhenrichtung zwischen den Kontaktnasen verkürzt, was beim Anlegen einer HF-Spannung insbesondere im MHz-Bereich vorteilhaft ist. Insbesondere wenn eine koaxiale Zuleitung vorgesehen ist, wie bei der oben beschriebenen Plasma-Behandlungsvorrichtung 30.

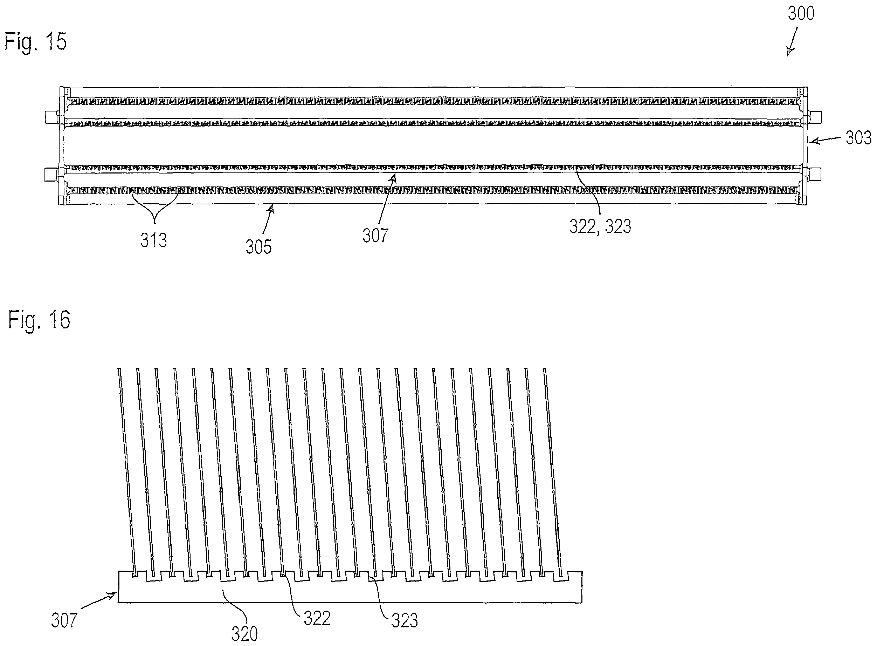

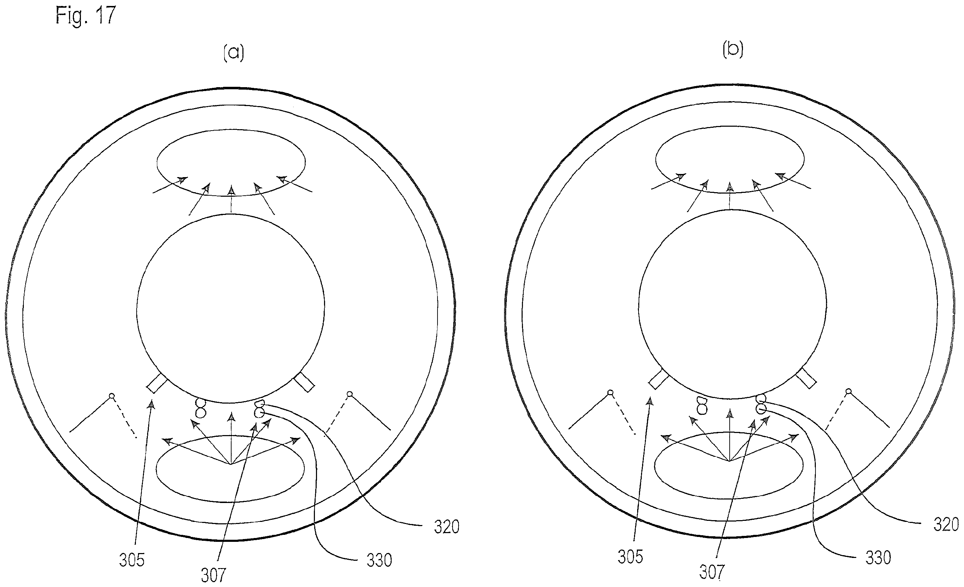

Anhand der Figuren 15 bis 16 wird noch eine weitere alternative Ausführungsform eines Waferbootes 300 näher erläutert, dass in einer Plasma-Behandlungsvorrichtung 30 des obigen Typs aber auch in klassischen Plasma-Behandlungsvorrichtungen eingesetzt werden kann. Dabei zeigt Fig. 15 eine schematische Draufsicht auf das Waferboot 300, Fig. 16 eine schematische Schnittansicht eines Teilbereichs desselben und Fig. 17 (a) und (b) schematische Querschnittansichten einer Plasma-Behandlungsvorrichtung mit einem solchen Waferboot 300. Während die bisherigen Waferboote jeweils des Typs waren, bei dem die Wafer parallel zur Längserstreckung des Waferbootes (und somit parallel zur Längserstreckung der Plasma-Behandlungsvorrichtung) aufgenommen wurden, ist das Waferboot des Typs, bei dem die Wafer Quer zur Längserstreckung des Waferbootes 300 aufgenommen werden. Insbesondere weist das Waferboot 300 einen klassischen Aufbau auf wie er beispielsweise in thermischen Diffusionsanlagen für Halbleiterwafer eingesetzt wird.

Wie in der Draufsicht gemäß Figur 15 zu erkennen ist, besitzt das Waferboot 300 eine langgestreckte Konfiguration, d.h. es besitzt in Längserstreckung (links-rechts in Figur 15) eine wesentlich größere Länge als in den übrigen Abmessungen. An den Enden des Waferbootes 300 ist jeweils eine Endplatte 303 vorgesehen, die bevorzugt aus Quarz ausgebildet ist. Sie kann aber auch aus einem anderen geeigneten nicht leitenden Material aufgebaut sein. Zwischen den Endplatten 303 erstrecken sich jeweils zwei in Querrichtung beabstandete Aufnahmeelemente 305 sowie zwei beabstandete Kontakt- und Führungselemente 307, die jeweils an den Endplatten 303 befestigt sind. Dabei liegen die Kontakt- und Führungselemente 307 in Querrichtung zwischen den Aufnahmeelementen 305.

Die Aufnahmeelemente 305 erstrecken sich, wie zuvor erwähnt, zwischen den Endplatten 303 und sind an diesen befestigt, insbesondere durch Verschweißen oder Bonden. Die Aufnahmeelemente 305 können auch aus Quarz bestehen und besitzen jeweils eine langgestreckte Stabform. Dabei besitzen die Aufnahmeelemente 305 im Wesentlichen einen rechteckigen Querschnitt, wobei im Wesentlichen" insbesondere auch Rechtecke mit abgerundeten Ecken umfassen soll. Grundsätzlich wäre es aber auch möglich, dass die Aufnahmeelemente 305 rund sind oder andere Formen aufweisen. Die 305 im Wesentlichen rechteckigen Aufnahmeelemente sind zueinander geneigt angeordnet und weisen in ihrer nach oben weisenden Schmalseite jeweils eine Vielzahl von Aufnahmeschlitzen 313 ausgebildet, die sich quer zur Längserstreckung des Aufnahmeelements 305 erstrecken, und zwar bevorzugt im Wesentlichen in einem 90° Winkel zur Längserstreckung. Die Aufnahmeschlitze 313 sind jeweils mit gleichmäßigem Abstand zueinander vorgesehen und sie "besitzen eine vorbestimmte (gleichbleibende) Tiefe zur Aufnahme eines Randbereichs eines jeweiligen aufzunehmenden Wafers oder eines Waferpaars, das beispielsweise in einer Back-to-Back Anordnung in dem Schlitz aufgenommen werden kann. Bevorzugt wird die Tiefe ungefähr einem Randausschlussbereich der Wafer entsprechend oder kleiner sein. Die Aufnahmeschlitze können in Längsrichtung um 1° bis 2° geneigt sein, sodass ein darin aufgenommener Wafer oder ein Waferpaar entsprechend zur Vertikalen geneigt angeordnet wird.

Nachfolgend werden nun die Kontakt- und Führungselemente 307 näher beschrieben, von denen in der Draufsicht gemäß Figur 15 zwei dargestellt sind. Die Kontakt- und Führungselemente 307 werden jeweils im Wesentlichen durch ein stabförmiges Element 320 aus einem elektrisch leitenden Material, wie beispielsweise Graphit gebildet, dessen Enden in geeigneter, nicht dargestellter Weise elektrisch kontaktierbar sind.

Die stabförmigen Elemente 320 besitzen jeweils einen im Wesentlichen runden Querschnitt, wie am besten in der Schnittansicht gemäß Figur 17 zu erkennen ist. In jedem stabförmigen Element 320 ist eine Vielzahl von Schlitzen 322 (Kontaktschlitz) und Schlitzen 323 (Isolierschlitz) vorgesehen, die sich in Längsrichtung abwechseln, wie am besten in Fig. 16 zu erkennen ist. Dabei besitzen die Schlitze 322 jeweils eine erste Tiefe und eine erste Breite, und die Schlitze 323 eine zweite Tiefe und eine zweite Breite, wobei die zweite Tiefe größer ist als die Erste und die zweite Breite größer ist als die Erste, wie nachfolgend noch näher erläutert wird. Die Schlitze 322, 323 besitzen die gleichen Abstände wie die Schlitze 313 der Aufnahmeelemente 303, wobei hier jeweils der Abstand von der Schlitzmitte eines jeweiligen Schlitzes zur Schlitzmitte des nächsten Schlitzes gemeint ist. Die Schlitze 322, 323 in den beabstandeten Kontakt- und Führungselementen 307 sind zueinander versetzt. Darüber sind die Schlitze 313, 322 und 323 zueinander so ausgerichtet, dass ein im Waferboot aufgenommener Wafer (ein Waferpaar) jeweils in zwei Schlitzen 313 (der beabstandeten Aufnahmeelemente), einem Schlitz 322 (eines Kontakt- und Führungselements 307) sowie einem Schlitz 323 (des anderen Kontakt- und Führungselements 307) aufgenommen ist. Dabei ist die Tiefe und Breite des Schlitzes 322 so gewählt, dass der Wafer (das Waferpaar) das Kontakt- und Führungselement 307 sicher kontaktiert. Die Tiefe und Breite des Schlitzes 323 ist hingegen so gewählt, dass der Wafer (das Waferpaar) das Kontakt- und Führungselement 307 sicher nicht kontaktiert, wie in Fig. 16 angedeutet ist.

Hierdurch wird sichergestellt, dass benachbarte Wafer (Waferpaare) die in in Längsrichtung benachbarten Schlitzen im Waferboot aufgenommen sind unterschiedliche der Kontakt- und Führungselemente 307 kontaktieren. Dies ist beispielsweise in den Figuren Fig. 17 (a) und (b) angedeutet, welche zum Beispiel Querschnittsansichten durch benachbarte Schlitze im Waferboot zeigen. Dabei ist bei der Ansicht gemäß Fig. 17 (A) der Schnitt so, dass er im linken Kontakt- und Führungselement 307 einen Schlitz 322 schneidet und im rechten Kontakt- und Führungselement 307 einen Schlitz 323. Entsprechend wird dann bei dem benachbarten Schlitz (Ansicht Fig. 17(b)) im linken Kontakt- und Führungselement 307 ein Schlitz 323 geschnitten und im rechten Kontakt- und Führungselement 307 einen Schlitz 322. Somit kann, wie der Fachmann erkennt, zwischen den Wafern (Waferpaaren) eine Spannung angelegt werden wenn zwischen den Kontakt- und Führungselementen 307 eine Spannung angelegt wird. Obwohl dies in Fig. 16 nicht dargestellt ist, könnten in den Schlitzen 323 jeweils isolierende Einsätze vorgesehen sein, die selbst entsprechende Aufnahmeschlitze für den Wafer (ein Waferpaar) aufweisen, oder die Schlitze 323 könnten eine isolierende Beschichtung aufweisen. Insbesondere ist es möglich, in dem Kontakt- und Führungselement 307 zunächst die Schlitze 323 auszubilden, und im Anschluss eine isolierende Beschichtung aufzubringen, die dann lokal bei der nachfolgenden Ausbildung der Schlitze 322 zerstört wird. Hierdurch ist eine elektrische Kontaktierung von Wafern nur im Bereich der Schlitze 322 möglich. Dies elektrische Kontaktierung kann über geeignete Kontakteinheiten, welche die Kontakt- und Führungselemente 307 kontaktieren erfolgen.

Die Kontakt- und Führungselemente 307 können relativ dünn ausgebildet sein. Um jedoch über die gesamte Länge des Waferbootes hinweg eine ausreichende Stabilität vorzusehen, ist bei der dargestellten Ausführungsform des Waferbootes 300 ein zweites stabförmiges Element 330 vorgesehen, das vertikal unterhalb der Kontakt- und Führungselemente 307 angeordnet ist, und sich zwischen den Endplatten 303 erstreckt. Das Element 330 ist bevorzugt aus einem elektrisch isolierenden Material mit ausreichender Stabilität ausgebildet, das keine Verunreinigungen in den Prozess einbringt und auch eine ausreichende thermische Stabilität aufweist, wie zum Beispiel Quarz oder ein anderes geeignetes Material. Das Kontakt- und Führungselement 307 kann, wie dargestellt direkt auf dem Element 330 aufliegen oder zwischen dem unteren Element 330 und dem Kontakt- und Führungselement 307 kann eine Vielzahl von Stützen vorgesehen sein. Das untere Element 330 kann wiederum eine runde Form aufweisen, besitzt aber keine Schlitze und weist dadurch eine höhere Stabilität gegenüber einem vergleichbaren Element mit Schlitzen auf, und kann das Kontakt- und Führungselement 307 daher über die Länge hinweg unterstützen.

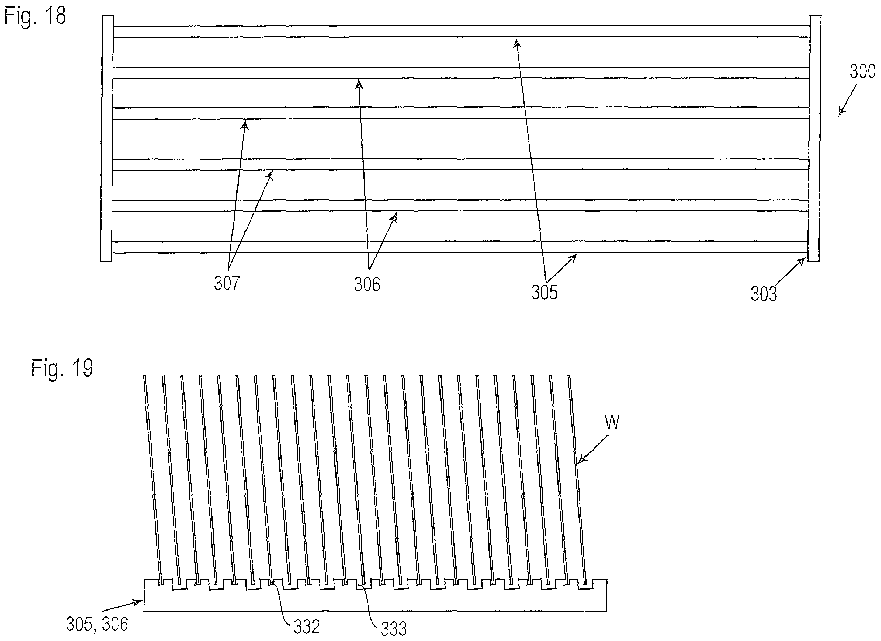

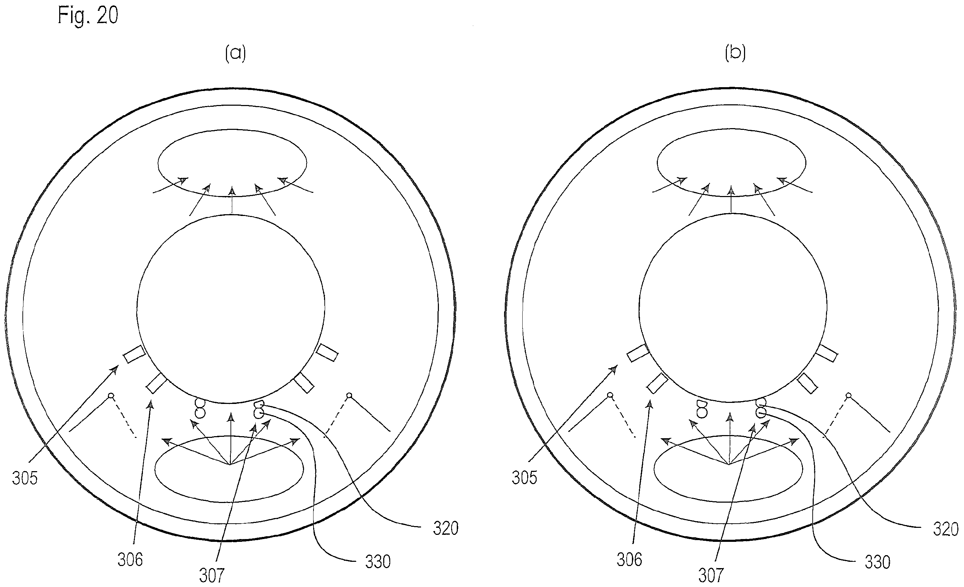

Die Figuren 18 bis 20 zeigen noch eine weitere alternative Ausführungsform eines Waferbootes 300. Diese Waferboot 300 ist in großen Zügen gleich dem zuvor anhand der Figuren 15 bis 17 beschriebenen Waferboot 300 und daher werden die selben Bezugszeichen für gleiche oder äquivalente Elemente verwendet. Dabei zeigt Fig. 18 eine schematische Draufsicht auf das Waferboot 300, Fig. 19 eine schematische Schnittansicht eines Teilbereichs desselben und Fig. 20 (a) und (b) schematische Querschnittansichten einer Plasma-Behandlungsvorrichtung mit einem solchen Waferboot 300. Auch bei diesem Waferboot 300 werden die Wafer Quer zur Längserstreckung des Waferbootes 300 aufgenommen.

Wie in der Draufsicht gemäß Figur 18 zu erkennen ist, besitzt das Waferboot 300 wiederum eine langgestreckte Konfiguration, wobei an den Enden des Waferbootes 300 jeweils eine Endplatte 303 vorgesehen ist, die wie zuvor beschrieben ausgebildet sein können. Zwischen den Endplatten 303 erstrecken sich jeweils zwei in Querrichtung beabstandete erste Aufnahmeelemente 305, zwei in Querrichtung beabstandete zweite Aufnahmeelemente 306, sowie zwei beabstandete Kontakt- und Führungselemente 307, die jeweils an den Endplatten 303 befestigt sind. Dabei liegen in Querrichtung die Kontakt- und Führungselemente 307 zwischen den zweiten Aufnahmeelementen 306 und die zweiten Aufnahmeelementen 306 jeweils zwischen einem ersten Aufnahmeelemente 305 und einem Kontakt- und Führungselement 307.

Die Kontakt- und Führungselemente 307 besitzen den gleichen Aufbau wie zuvor beschrieben, mit oberen und unteren Stabelementen 320, 330 sowie Kontaktschlitzen 222 und Isolierschlitzen 223, die in den jeweiligen Kontakt- und Führungselementen 307 versetzt zueinander angeordnet sind. Hierdurch wird jeder zweite im Waferboot aufgenommene Wafer durch eines der Kontakt- und Führungselemente 307 kontaktiert während die weiteren Wafer durch das andere Kontakt- und Führungselement 307 kontaktiert werden.

Die ersten und zweiten Aufnahmeelemente 305, 306 erstrecken sich, zwischen den Endplatten 303 und sind wie oben beschrieben an diesen befestigt. Die ersten und zweiten Aufnahmeelemente 305, 306 können wieder aus Quarz bestehen und besitzen jeweils eine langgestreckte Stabform. Dabei besitzen die ersten und zweiten Aufnahmeelemente 305, 306 jeweils eine Grundform, wie bei dem Waferboot 300 gemäß den Figuren 15 bis 17. Sie weisen auch jeweils eine Vielzahl von Schlitzen 330 entsprechend der Vielzahl von Aufnahmeschlitzen 313 gemäß den Figuren 15 bis 17 auf. Die Schlitze 330 weisen jedoch zwei Schlitztypen auf, die sich hinsichtlich ihrer Größe und auch Funktion unterscheiden.

Der erste Schlitztyp, der als Aufnahmeschlitz 332 dient, besitzt eine erste Tiefe und eine erste Breite, die geeignet sind einen Randbereich eines jeweiligen aufzunehmenden Wafers oder eines Waferpaars, beispielsweise in einer Back-to-Back Anordnung, kontaktierend in dem Schlitz aufzunehmen. Bevorzugt wird die Tiefe ungefähr einem Randausschlussbereich der Wafer entsprechend oder kleiner sein. Der zweite Schlitztyp, der als Isolierschlitz 333 dient, besitzt eine zweite Tiefe und eine zweite Breite, die jeweils größer sind als die erste Tiefe und die erste Breite. Die Isolierschlitze 333 sind jeweils geeignet einen Randbereich eines jeweiligen aufzunehmenden Wafers oder eines Waferpaars freistehend, d.h. ohne Kontakt hiermit in dem Schlitz aufzunehmen.

Die Aufnahmeschlitze 332 und die Isolierschlitze 333 wechseln sich in Längsrichtung der Aufnahmeelemente 305, 306 ab, wie in der Ansicht in Fig. 19 zu erkennen ist. Die Aufnahmeschlitze 332 und die Isolierschlitze 333 der ersten Aufnahmeelemente 305 sind zueinander ausgerichtet. Auch die Aufnahmeschlitze 332 und die Isolierschlitze 333 der zweiten Aufnahmeelemente 306 sind zueinander ausgerichtet. Ferner sind die Aufnahmeschlitze 332 der ersten Aufnahmeelemente 305 mit den Isolierschlitzen 333 der zweiten Aufnahmeelemente 306 ausgerichtet und die Isolierschlitze 333 der ersten Aufnahmeelemente 305 mit den Aufnahmeschlitzen 332 der zweiten Aufnahmeelemente 306. Mit anderen Worten sind die Aufnahme- und Isolierschlitze 332, 333 der ersten Aufnahmeelemente 305 zu den Aufnahme- und Isolierschlitzen 332, 333 der zweiten Aufnahmeelemente 306 versetzt.

Hierdurch wird jeder zweite im Waferboot aufgenommene Wafer durch die ersten Aufnahmeelemente 305 aufgenommen und getragen während die weiteren Wafer durch die zweiten Aufnahmeelemente 306 aufgenommen und getragen werden. Hierdurch wird ferner erreicht, dass alle Wafer die durch die ersten Aufnahmeelemente 305 aufgenommen und getragen werden dasselbe Kontakt- und Führungselement 307 kontaktieren, während die weiteren durch die zweiten Aufnahmeelemente 306 aufgenommenen und getragenen Wafer das andere Kontakt- und Führungselement 307 kontaktieren. Ein entsprechendes wechselseitiges Tragen und Kontaktieren ist in den Fig. 20 (a) und (b) angedeutet. Diese Konfiguration kann im Betrieb einen Kurzschluss zwischen benachbarten Wafern über die ersten und zweiten Aufnahmeelemente 305, 306 für den Fall verhindern, dass sich während einer Plasmabehandlung (die zum Beispiel eine Abscheidung leitender Schichten auf den Wafern bezweckt) leitende Schichten auf den ersten und zweiten Aufnahmeelementen 305, 306 abscheiden.

Bei dieser Konfiguration wäre es auch möglich die ersten und zweiten Aufnahmeelemente 305, 306 leitend auszubilden zusätzlich auch hierüber eine Spannung zwischen im Waferboot 300 aufgenommenen Wafern anzulegen, um Beispielsweise die Kontaktfläche zu den Wafern und somit die Fläche für die Einleitung elektrischer Leistung zu erhöhen.

Nachfolgend wird nun der Betrieb der Plasma-Behandlungsvorrichtung 30 unter Bezugnahme auf die Zeichnungen näher erläutert, wobei beispielhaft als Behandlung eine durch Plasma unterstützte Silicimnitrid oder Aluminiumoxidabscheidung in einem durch 13,56 MHz angeregten Plasma beschrieben wird. Die Behandlungsvorrichtung 30 kann aber auch für andere durch Plasma unterstützte Abscheidungsprozesse eingesetzt werden, wobei das Plasma auch durch andere Frequenzen zum Beispiel im Bereich 40kHz angeregt werden kann. Die Koaxialleitung 74 ist aber besonders für Frequenzen im MHz-Bereich vorgesehen und optimiert.

Zunächst wird davon ausgegangen wird, dass ein beladenes Waferboot 1 des oben beschrieben Typs (gemäß Fig. 1) in die Prozesskammer 38 geladen ist und diese durch den nicht dargestellten Schließmechanismus verschlossen ist. Dabei ist das Waferboot 1 so beladen, dass in jedem der Aufnahmeschlitze 11 insgesamt 12 Wafer, im vorliegenden Beispiel insbesondere Si-Wafer, aufgenommen sind und zwar jeweils sechs an jeder der Platten 6. Dabei sind die Wafer so aufgenommen, dass sie sich paarweise gegenüber liegen, wie es in der Technik bekannt ist.

In diesem Zustand befindet sich der Innenraum auf Umgebungsdruck und kann beispielsweise über die Gassteuereinheit 60 (in Kombination mit der Unterdruck-Steuereinheit 62) mit N₂ gespült bzw. geflutet werden.

Das Rohrelement 36 und somit die Prozesskammer 38 werden über die nicht gezeigte Heizeinrichtung erwärmt, um das Waferboot 1 und die darin aufgenommenen Wafer auf eine vorbestimmte, für den Prozess vorteilhafte Prozesstemperatur zu erwärmen. Die Umlenkelemente befinden sich in der zweiten Position (gestrichelt in Figur 5 dargestellt), um eine Erwärmung über Konvektion nicht zu beeinträchtigen, Dabei kann jedoch eine Erwärmung der innen liegenden Platten 6 des Waferbootes 1 sowie der dazwischen aufgenommenen Wafer über eine Erwärmung des Rohrelements 36 langwierig sein.

Daher kann, wenn ein Waferboot 1 des oben beschriebenen Typs vorgesehen ist, zur Unterstützung der Erwärmung über die elektrische Steuereinheit 64 eine Gleich- oder Niederfrequenz-Wechselspannung an das Waferboot 1 angelegt werden. Dabei ist die Spannung ausreichend hoch, so dass über die hochohmigen Abstandselemente 22 Strom geleitet wird und diese als Widerstandsheizelemente wirken. Hierdurch wird Heizleistung speziell in die Aufnahmeschlitze 11 eingebracht, sodass gegenüber einer Aufheizung von außen wesentlich schneller die vorbestimmte Temperatur erreicht werden kann. Je nach Widerstand der Abstandselemente werden Spannungen im Bereich von wenigstens 200 V bis ungefähr 1 kV in Betracht gezogen, um einen ausreichenden Stromfluss und eine ausreichende Erwärmung der Abstandselemente 22 zu erreichen.

Wenn die vorbestimmte Temperatur des Waferbootes 1 und damit der ganzen Einheit (Waferboot 1, Wafer und Rohrelement 36) erreicht ist, kann die elektrische Steuereinheit 64 zunächst deaktiviert werden und die Prozesskammer wird über die Unterdruck-Steuereinheit 62 auf einen vorbestimmten Unterdruck abgepumpt. Die Umlenkelemente 50 werden automatisch durch den sich einstellenden Unterdruck oder auch aktiv in die erste Position (durchgezogenen Linie in Fig. 5) bewegt. Beim Erreichen des vorbestimmten Unterdrucks wird über die Gassteuereinheit 60 ein gewünschtes Prozessgas wie zum Beispiel SiH₄/NH₃ für eine Siliciumnitridabscheidung in einem definierten Mischungsverhältnis in Abhängigkeit von den geforderten Schichteigenschaften eingeleitet, während über die Unterdruck-Steuereinheit 62 weiterhin der Unterdruck durch Absaugen des eingeleiteten Prozessgases aufrecht erhalten wird. Das über die Pumpe 70 abgesaugte Prozessgas kann zu diesem Zeitpunkt mit N₂ verdünnt werden, wie es in der Technik bekannt ist, Hierfür wird über die Gassteuereinheit 60 und die entsprechend Leitung der Pumpe N₂ zugeführt. Durch die spezielle Anordnung der Gasführungen 44, 46 in Kombination mit den Umlenkelementen 50 wird innerhalb der Prozesskammer hauptsächlich eine Gasströmung durch die Aufnahmeschlitze 11 des Waferbootes 1 erzeugt. Diese kann durch die spezielle Anordnung der Gasführungen 44, 46 über die Breite und Länge des Waferbootes homogen ausgebildet werden.

Über die elektrische Steuereinheit 64 wird nun eine HF-Spannung mit einer Frequenz von 13,56 MHz an das Waferboot 1 angelegt. Diese bewirkt eine Plasmazündung des Prozessgases zwischen den Platten 6 und insbesondere zwischen den im Waferboot 1 aufgenommenen Wafern und es kommt zu einer durch Plasma unterstützte Siliciumnitridabscheidung auf den Wafern. Die Gasströmung wird während des Abscheideprozesses aufrecht erhalten, um eine lokale Verarmung des Prozessgases bezüglich der aktiven Komponenten zu vermeiden. Nach einer ausreichenden Abscheidezeit für die gewünschte Schichtdicke wird die elektrische Steuereinheit 64 wiederum deaktiviert und die Gaszuführung gestoppt, bzw. wieder N₂ umgestellt, um die Prozesskammer 38 zu spülen und gegebenenfalls gleichzeitig zu belüften (Angleichung an den Atmosphärendruck). Anschließend kann die Prozesskammer 38 dann wieder auf Umgebungsdruck gebracht werden.

Wie sich aus der obigen Beschreibung ergibt, bietet das Waferboot 1 des obigen Typs - unabhängig von anderen Komponenten der Behandlungsvorrichtung - den Vorteil, dass es während der Aufheizphase eine Aufheizung direkt im Bereich der Aufnahmeschlitze 11 zwischen den Platten 6 des Waferbootes 1 erlaubt. Diese ist über die elektrisch leitenden Abstandselemente 22 möglich. Dadurch, dass sie speziell hochohmig gewählt sind, beeinträchtigen sie die Plasmabildung beim Anlegen der HF-Spannung nicht wesentlich.

Die spezielle Gasführung über die Gasführungen 44, 46 bietet - wiederum unabhängig von anderen Komponenten der Behandlungsvorrichtung, wie dem speziellen Waferboot 1 - den Vorteil einer homogenen Gasströmung in der Prozesskammer 38. Insbesondere in Kombination mit den Umlenkelementen kann eine gezielte Gasströmung durch die Aufnahmeschlitze erreicht werden. Hierdurch wird ein guter Gasaustausch und eine homogene Gasverteilung im Reaktionsraum gewährleistet und es können gegebenenfalls geringere Flussraten für die Prozessgase verwendet werden.

Die spezielle Koaxialleitung 74 erlaubt - wiederum unabhängig von anderen Komponenten der Behandlungsvorrichtung, wie dem speziellen Waferboot 1 mit elektrisch leitenden Abstandselementen 22 oder der speziellen Gasführung - den Vorteil, dass effizient Spannungen im MHz-Bereich, insbesondere mit 13,56 MHz an das Waferboot angelegt werden können. Elektrische Verluste können reduziert werden. Hierzu tragen auch die spezielle Ausgestaltung der Kontaktbereiche des Waferbootes 1, wie die Abmessungen und Formen der Kontaktnasen bei.

Die Waferboote 100, 200 und 300 bieten gegenüber dem Waferboot 1 eine deutlich verringerte thermische Masse und die in großen Teilen frei stehenden Wafer lassen sich besser erwärmen. Im Bereich der Auflagen 102, 104 bzw. der Platten 202, 204 können wieder um elektrisch leitende Abstandhalter eingesetzt werden, um hier während der Aufheizphase eine lokale Zusatzheizung vorzusehen. Insbesondere kann ein Ausgleich für die thermische Masse der Auflagen bzw. Platten geschaffen werden, die im frei stehenden Bereich der Wafer nicht vorhanden ist. Das Waferboot 300 erlaubt eine andere Ausrichtung der Wafer, die insbesondere bei gleichbleibender Prozesskammer die Aufnahme größerer Wafer ermöglicht.

Die Behandlungsvorrichtung 30 und das Waferboot 1 wurden anhand bestimmter Ausführungsformen der Erfindung unter Bezugnahme auf die Zeichnung näher erläutert, ohne auf die konkret dargestellten Ausführungsformen begrenzt zu sein. Insbesondere könnten zum Beispiel die Gasführungen 44, 46 unterschiedliche Formen annehmen oder unterschiedlich angeordnet sein, wie auch schon durch die Fig. 7 bis 9 angedeutet wurde. Auch die Platten 6 des Waferbootes 1 können andere Abmessungen aufweisen und insbesondere für die Aufnahme einer anderen Anzahl von Wafern dimensioniert sein, Die Behandlungsvorrichtung ist in einer horizontalen Ausrichtung dargestellt, und diese stellt auch eine bevorzugt Ausrichtung dar. Die meisten vorteilhaften Aspekte der vorliegenden Anmeldung gelten aber auch für eine Vertikalkammer mit einem vertikal angeordneten Rohrelement, wobei hier Ortsangaben wie oben, unten entsprechend in seitliche Ortsangaben umzudeuten sind. Dies gilt insbesondere für die Anordnung der Gasführungsrohre in Bezug auf das Waferboot beziehungsweise einen Aufnahmeraum hierfür.

## Patentansprüche

1. Waferboot (1) für die Plasmabehandlung von scheibenförmigen Wafern (W), insbesondere Halbleiterwafern für Halbleiter- oder Photovoltaikanwendungen, das folgendes aufweist:
eine Vielzahl von parallel zueinander angeordneten Platten (6) aus einem elektrisch leitenden Material, die an ihren zueinander weisenden Seiten jeweils wenigstens eine Aufnahme für einen Wafer (W) aufweisen, die einen Aufnahmebereich der Platten (6) definieren;
eine Vielzahl von Abstandselementen (22), die zwischen direkt benachbarten Platten (6) angeordnet sind, um die Platten (6) parallel anzuordnen;
**dadurch gekennzeichnet, dass** die Abstandselemente (22) elektrisch leitend sind.

2. Waferboot nach Anspruch 1, wobei die Abstandselemente jeweils gleichmäßig um den Aufnahmebereich der Platten herum angeordnet sind.

3. Waferboot nach einem der vorhergehenden Ansprüche, wobei jeweils wenigstens vier der Abstandselemente um einen entsprechenden Aufnahmebereich der Platten herum angeordnet sind.

4. Waferboot nach einem der vorhergehenden Ansprüche, wobei der Widerstand der Abstandselemente derart gewählt ist, dass bei einer Beaufschlagung des Waferbootes mit einer Hochfrequenzspannung nur der kleinere Teil der eingekoppelten Hochfrequenzleistung an den Abstandelementen in Wärme ungesetzt wird.

5. Waferboot nach einem der vorhergehenden Ansprüche, wobei die Abstandselemente jeweils einen Widerstand von wenigstens 20 kΩ, bevorzugt im Bereich von 40 kΩ aufweisen.

6. Waferboot nach einem der vorhergehenden Ansprüche, wobei die Abstandselemente aus dem Grundmaterial Polysilizium bestehen und ein Widerstand der Abstandelemente über eine Dotierung des Grundmaterials eingestellt ist.

7. Waferboot nach einem der vorhergehenden Ansprüche, wobei die Platten an ihren Längsenden jeweils Kontaktnasen (13) aufweisen, die über Kontaktblöcke (15) mit Kontaktnasen anderer Platten verbunden sind, wobei die Kontaktnasen direkt benachbarter Platten in unterschiedlichen Ebenen liegen und die Kontaktblöcke jeweils jede zweite Platte miteinander verbinden, und wobei die kombinierte thermische Masse der Summe der Kontaktblöcke und der Summe der Kontaktnasen bevorzugt kleiner ist als die thermische Masse des sonstigen Waferbootes.

8. Waferboot nach Anspruch 7, wobei die kombinierte thermische Masse der Summe der Kontaktblöcke und der Summe der Kontaktnasen kleiner ist als 1/10 der thermischen Masse des sonstigen Waferbootes.

9. Waferboot nach einem der Ansprüche 6 bis 8, wobei die Zuleitungsimpedanz über jeweils stromdurchflossene Kontaktblöcke und zwei Kontaktnasen kleiner ist als die Impedanz eines Plasmas, das im Betrieb zwischen einem mit den Kontaktnasen in Kontakt stehenden Waferpaar brennt.

10. Plasma-Behandlungsvorrichtung (30) für Wafer, insbesondere Halbleiterwafer, die folgendes Aufweist:
einen Prozessraum umfassend ein Waferboot (1) nach einem der vorhergehenden Ansprüche;
Mittel zum Steuern oder Regeln einer Prozessgasatmosphäre in dem Prozessraum; und
wenigstens eine Spannungsquelle, die mit den Platten (6) des Waferbootes (1) in geeigneter Weise verbindbar ist, um zwischen direkt benachbarten Platten (6) des Waferbootes (1) eine elektrische Spannung anzulegen, wobei die wenigstens eine Spannungsquelle geeignet ist wenigstens eine Gleichspannung oder eine Niederfrequenz-Wechselspannung und eine Hochfrequenz-Wechselspannung anzulegen.

11. Plasma-Behandlungsvorrichtung nach Anspruch 10, wobei die Vorrichtung wenigsten eine Zusatz-Heizeinheit zum Aufheizen des Prozessraums und der darin aufgenommenen Wafer aufweist.

12. Verfahren zur Plasmabehandlung von Wafern (W), bei dem eine Vielzahl von Substraten, insbesondere Halbleiterwafern, in einem Waferboot (1) nach einem der Ansprüche 1-9 in dem Prozessraum einer Plasma-Behandlungsvorrichtung (30) nach Anspruch 10 oder 11 aufgenommen ist, wobei das Verfahren die folgenden Schritte aufweist:
Anlegen einer Gleichspannung oder einer Niederfrequenz-Wechselspannung an die Platten (6) des Waferbootes (1) während einer Aufheizphase, derart, dass sich die Abstandselemente (22) aufgrund eines Stromflusses durch sie hindurch erwärmen; und
Anlegen einer Hochfrequenz-Wechselspannung an die Platten (6) des Waferbootes (1), um während einer Prozessphase zwischen den daran aufgenommenen Wafern (W) ein Plasma zu erzeugen.

13. Verfahren nach Anspruch 12, wobei die Temperatur in dem Prozessraum gesteuert oder geregelt wird und die Umschaltung zwischen dem Anlegen der Gleichspannung oder der Niederfrequenz-Wechselspannung und dem Anlegen der Hochfrequenz-Wechselspannung erfolgt, wenn die Temperatur der Wafer eine vorbestimmte Temperatur erreicht oder überschreitet.

14. Verfahren nach Anspruch 12 oder 13, wobei die angelegte Gleichspannung oder Niederfrequenz-Wechselspannung eine wesentlich größere Spannung aufweist als die Hochfrequenz-Wechselspannung.

15. Verfahren nach einem der Ansprüche 12 bis 14, wobei die Gasatmosphäre in dem Prozessraum gesteuert oder geregelt wird.

## Claims

1. Wafer boat (1) for the plasma treatment of disc-shaped wafers (W), in particular semiconductor wafers for semiconductor or photovoltaic applications, comprising:
a plurality of plates (6) positioned parallel to one another made of an electrically conductive material, each plate having at least one receptacle for a wafer (W) on each side facing another plate, which define a receiving space of the plates (6);
a plurality of spacer elements (22), which are positioned between directly adjacent plates (6) in order to position the plates (6) parallel to each other;
**characterised in that** the spacer elements (22) are electrically conductive.

2. Wafer boat according to claim 1, wherein the spacer elements are evenly distributed around the receiving space of the plates.

3. Wafer boat according to one of the preceding claims, wherein at least four of the spacer elements are distributed around a respective receiving space of the plates.

4. Wafer boat according to one of the preceding claims, wherein the resistance of the spacer elements is such that when the wafer boat is supplied with a high-frequency voltage, only the smaller part of the high-frequency power introduced into the spacer elements is transformed into heat.

5. Wafer boat according to one of the preceding claims, wherein each of the spacer elements has a resistance of at least 20 kΩ, and preferably in the region of 40 kΩ.

6. Wafer boat according to one of the preceding claims, wherein the spacer elements are made of polysilicon as a base material, and wherein a resistance of the spacer elements is set by doping the base material.

7. Wafer boat according to one of the preceding claims, wherein the plates each have contact projections at their longitudinal ends which are connected via contact blocks with the contact projections of other plates, wherein the contact projections of directly adjacent plates are located at different height levels, and wherein the contact blocks connect every second one of the plates, respectively, and wherein the combined thermal mass of the sum of the contact blocks and the sum of the contact projections is preferably smaller than the thermal mass of the rest of the wafer boat.

8. Wafer boat according to claim 7, wherein the combined thermal mass of the sum of the contact blocks and the sum of the contact projections is smaller than 1/10 of the thermal mass of the remainder of the wafer boat.

9. Wafer boat according to one of claims 6-8, wherein the impedance of the supply path over via contact blocks and two contact projections in which electrical current flows is smaller than the impedance of a plasma which is burning during operation between a wafer pair which is in contact with the contact projections.

10. Plasma treatment apparatus (30) for wafers, in particular semiconductor wafers, comprising:
a process chamber including a wafer boat (1) according to one of the preceding claims;
means for controlling or regulating a process gas atmosphere in the process chamber; and
at least one source of voltage which is connectable to the plates (6) of the wafer boat (1) in a suitable manner, in order to supply an electrical voltage between directly adjacent plates (6) of the wafer boat (1), wherein the at least one source of voltage is suitable for applying at least one of a DC-voltage and a low-frequency AC voltage and a high-frequency AC voltage.

11. Plasma treatment apparatus according to claim 10, wherein the apparatus has at least one additional heating unit for heating the process chamber and the wafers inserted into the process chamber.

12. A method for the plasma treatment of wafers (W), in which a plurality of substrates, in particular semiconductor wafers, which are received in a wafer boat (1) according to one of claims 1-9 is inserted in the process space of a plasma treatment apparatus (30) according to claim 10 or 11, wherein the method comprises the following steps:
applying a DC-voltage or a low-frequency AC-voltage to the plates (6) of the wafer boat (1) during a heating phase in such a way that the spacer elements (22) heat up due to a flow of current therethrough; and
applying a high-frequency AC-voltage to the plates (6) of the wafer boat (1), in order to generate a plasma between the wafers (W) inserted therein during a processing phase.

13. Method according to claim 12, wherein the temperature in the process space is controlled or regulated, and wherein the switching between applying a DC-voltage or a low-frequency AC-voltage and applying a high-frequency AC-voltage takes place when the temperature of the wafers reaches or exceeds a pre-determined temperature.

14. Method according to claim 12 or 13, wherein the applied DC-voltage or low-frequency AC-voltage is a substantially larger voltage than the high-frequency AC-voltage.

15. Method according to one of claims 12 to 14, wherein the gas atmosphere in the process space is controlled or regulated.

## Revendications

1. Nacelle porte-plaquettes (1) pour le traitement au plasma de plaquettes en forme de disque (W), en particulier de plaquettes semiconductrices pour des applications semiconductrices ou photovoltaïques, comprenant :
une pluralité de plaques (6) disposées parallèlement les unes aux autres constituées d'un matériau électriquement conducteur, chaque plaque comportant au moins un réceptacle pour une plaquette (W) faisant face de chaque côté à une autre plaque qui définit une zone de réception des plaques (6) ;
une pluralité d'éléments d'espacement (22) disposés entre des plaques directement adjacentes (6) pour disposer les plaques (6) parallèlement les unes aux autres ;
**caractérisé en ce que** les éléments d'espacement (22) sont électriquement conducteurs.

2. Nacelle porte-plaquettes selon la revendication 1, dans laquelle les éléments d'espacement sont disposés uniformément autour de la zone de réception des plaques.

3. Nacelle porte-plaquettes selon l'une quelconque des revendications précédentes, dans laquelle au moins quatre des éléments d'espacement sont disposés autour d'une zone de réception respective des plaques.

4. Nacelle porte-plaquettes selon l'une quelconque des revendications précédentes, dans laquelle la résistance des éléments d'espacement est telle que quand la nacelle porte-plaquettes est soumise à une tension haute fréquence, seule la plus petite partie de la puissance haute fréquence introduite dans les éléments d'espacement est transformée en chaleur.

5. Nacelle porte-plaquettes selon l'une quelconque des revendications précédentes, dans laquelle chacun des éléments d'espacement a une résistance d'au moins 20 k•, et de préférence de l'ordre de 40 k•.

6. Nacelle porte-plaquettes selon l'une quelconque des revendications précédentes, dans laquelle les éléments d'espacement sont constitués de silicium polycristallin en tant que matériau de base, et dans laquelle une résistance des éléments d'espacement est fixée au moyen d'un dopage du matériau de base.

7. Nacelle porte-plaquettes selon l'une quelconque des revendications précédentes, dans laquelle les plaques ont chacune des saillies de contact au niveau de leurs extrémités longitudinales qui sont connectées au moyen de blocs de contact aux saillies de contact d'autres plaques, les saillies de contact des plaques directement adjacentes étant disposées dans des plans de hauteur différents, et les blocs de contact connectant chaque seconde une des plaques, respectivement, et la masse thermique combinée de l'ensemble des blocs de contact et de l'ensemble des saillies de contact étant de préférence inférieure à la masse thermique du reste de la nacelle porte-plaquettes.

8. Nacelle porte-plaquettes selon la revendication 7, dans laquelle la masse thermique combinée de l'ensemble des blocs de contact et de l'ensemble des saillies de contact est inférieure à 1/10 de la masse thermique du reste de la nacelle porte-plaquettes.

9. Nacelle porte-plaquettes selon l'une quelconque des revendications 6 à 8, dans laquelle l'impédance du trajet d'alimentation à travers des blocs de contact et de deux saillies de contact dans lesquelles circule un courant électrique est inférieure à l'impédance d'un plasma qui brûle en cours d'utilisation entre une paire de plaquettes en contact avec les saillies de contact.

10. Appareil de traitement au plasma (30) pour plaquettes, en particulier des plaquettes semiconductrices, comprenant :
une chambre de traitement comportant une nacelle porte-plaquettes (1) selon l'une des revendications précédentes ;
des moyens pour contrôler ou réguler une atmosphère de gaz de traitement dans la chambre de traitement ; et
au moins une source de tension qui peut être connectée aux plaques (6) de la nacelle porte-plaquettes (1) d'une façon appropriée pour appliquer une tension électrique entre des plaques directement adjacentes (6) de la nacelle porte-plaquettes (1), ladite au moins une source de tension étant adaptée pour appliquer au moins une tension parmi une tension continue DC et une tension alternative AC basse fréquence et une tension alternative AC haute fréquence.

11. Appareil de traitement au plasma selon la revendication 10, dans lequel l'appareil comprend au moins une unité de chauffage auxiliaire pour chauffer la chambre de traitement et les plaquettes introduites dans la chambre de traitement.

12. Procédé de traitement au plasma de plaquettes (W), dans lequel une pluralité de substrats, en particulier des plaquettes semiconductrices, qui sont placés dans une nacelle porte-plaquettes (1) selon l'une quelconque des revendications 1 à 9 est introduite dans la chambre de traitement d'un appareil de traitement au plasma (30) selon la revendication 10 ou 11, le procédé comprenant les étapes suivantes :
l'application d'une tension continue DC ou d'une tension alternative AC basse fréquence aux plaques (6) de la nacelle porte-plaquettes (1) pendant une phase de chauffage de telle sorte que les éléments d'espacement (22) chauffent en raison du passage d'un courant à travers elles ; et
l'application d'une tension alternative AC haute fréquence sur les plaques (6) de la nacelle porte-plaquettes (1) pour produire un plasma entre les plaquettes (W) insérées dans celle-ci pendant une phase de traitement.

13. Procédé selon la revendication 12, dans lequel la température dans la chambre de traitement est contrôlée ou régulée et dans lequel la commutation entre une application d'une tension continue DC ou d'une tension alternative AC basse fréquence et une application d'une tension alternative AC haute fréquence se produit quand la température de la tranche atteint ou dépasse une température prédéterminée.

14. Procédé selon la revendication 12 ou 13, dans lequel la tension continue DC appliquée ou la tension alternative AC basse fréquence est une tension sensiblement supérieure à la tension alternative AC haute fréquence.

15. Procédé selon l'une quelconque des revendications 12 à 14, dans lequel l'atmosphère de gaz dans la chambre de traitement est contrôlée ou régulée.
